(19) Europäisches Patentamt
European Patent Office
Office européen des brevets

(11) **EP 4 487 380 B1**

(12) **EUROPEAN PATENT SPECIFICATION**

(45) Date of publication and mention
of the grant of the patent:
**03.09.2025  Bulletin 2025/36**

(21) Application number: **23705611.4**

(22) Date of filing: **23.02.2023**

(51) International Patent Classification (IPC):
*H10D 30/01* (2025.01)     *H10D 48/00* (2025.01)
*H10D 62/10* (2025.01)     *H10D 62/81* (2025.01)
*H10D 62/824* (2025.01)    *H10D 62/85* (2025.01)
*B82Y 10/00* (2011.01)     *G06N 10/40* (2022.01)

(52) Cooperative Patent Classification (CPC):
**H10D 30/014; H10D 48/3835; H10D 48/385;
H10D 62/118; H10D 62/814; H10D 62/824;
H10D 62/8503; B82Y 10/00; G06N 10/40**

(86) International application number:
**PCT/EP2023/054584**

(87) International publication number:
**WO 2023/161360 (31.08.2023 Gazette 2023/35)**

(54) **ELECTRON HOLE SPIN QUBIT TRANSISTOR, AND METHODS FOR FORMING A ELECTRON HOLE SPIN QUBIT TRANSISTOR**

ELEKTRON-LOCH SPIN-QUBIT-TRANSISTOR UND VERFAHREN ZUR HERSTELLUNG EINES ELEKTRON-LOCH SPIN-QUBIT-TRANSISTORS

TRANSISTOR À BITS QUANTIQUES DE SPIN DE TROU D'ÉLECTRONS,  ET PROCÉDÉS DE FORMATION D'UN TRANSISTOR DE BITS QUANTIQUES DE SPIN DE TROU D'ÉLECTRONS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:  **28.02.2022  EP 22159157**

(43) Date of publication of application:
**08.01.2025  Bulletin 2025/02**

(60) Divisional application:
**25191437.0**

(73) Proprietor: **Epinovatech AB
223 63 Lund (SE)**

(72) Inventor: **OLSSON, Martin Andreas
223 63 Lund (SE)**

(74) Representative: **Zacco Sweden AB
P.O. Box 5581
Löjtnantsgatan 21
114 85 Stockholm (SE)**

(56) References cited:
**EP-A1- 2 075 745          JP-A- 2003 101 069
US-A1- 2019 252 377     US-A1- 2020 027 972
US-A1- 2020 161 531     US-B1- 10 387 792**

## Description

### Technical field

The inventive concept described herein generally relates to spin qubit transistors and quantum computers.

### Background

The idea of the quantum computer has been around since the early days of today's classic computers. In a quantum computer, the classical bits of a computer are represented by qubits. In accordance with quantum physics, the qubits can be in several states at one time. Conventional spin qubits are based on a heterostructure in e.g. Si(1-x)Ge(x)/Ge or AlGaAs/GaAs using electrostatic confinement. A 2-dimensional electron gas (2DEG) is used to create a potential energy landscape by applying a voltage to gate electrodes. This is, for example, known from patent publications US 2020 0027972 A1 and US 2019 0252377 A1. Qubits using physical quantum dots are also known, for example, from patent publication EP 2 075 745 A1. To be able to realize quantum computers, there is still a need for improvement.

### Summary of the invention

It is an object of the present inventive concept to provide a spin qubit transistor being suitable for scalability. It is a further objective to provide a quantum computer employing a plurality of the spin qubit transistor. These and other objectives of the inventive concept are at least partly met by the invention as defined in the independent claims. Preferred embodiments are set out in the dependent claims.

In this text, abbreviations for the natural elements will be used in accordance with the periodic table. For example, Al means aluminum, Ga means gallium, In means indium, N means nitrogen, Si means silicon.

According to a first aspect, there is provided an electron-hole spin qubit transistor comprising:

a base layer;
a first qubit comprising:
a first computing semiconductor island and a first readout semiconductor island arranged with a distance in the range of 3-10 nm therebetween;
a second qubit comprising:
a second computing semiconductor island and a second readout semiconductor island arranged with a distance in the range of 3-10 nm therebetween;
wherein each of said semiconductor islands has a size causing each of said semiconductor islands to exhibit 3-dimensional quantum confinement of a single electron-hole, and wherein each of said semiconductor islands forms a heterojunction with the base layer;
wherein the spin qubit transistor further comprises:

a supporting material arranged on top of and embedding each of said semiconductor islands;
a source terminal being in electrical contact with the first computing semiconductor island via the supporting material;
a drain terminal being in electrical contact with the second computing semiconductor island via the supporting material;
a first gate terminal arranged over the first computing semiconductor island, the first gate terminal being configured for microwave modulation of the spin state of the first computing semiconductor island;
a second gate terminal arranged over the first readout semiconductor island, the second gate terminal being configured for readout of a state of the first readout semiconductor island;
a third gate terminal arranged over the second computing semiconductor island, the third gate terminal being configured for microwave modulation of the spin state of the second computing semiconductor island;
a fourth gate terminal arranged over the second readout semiconductor island, the fourth gate terminal being configured for readout of a state of the second readout semiconductor island;
wherein said first computing semiconductor island and said second computing semiconductor island are configured to have a unique resonance frequency respectively.

It is a realization that a qubit may comprise physical semiconductor islands. Thus, the qubits may be realized without the use of 2-dimensional electron gas. The inventor has realized that it is advantageous to encode quantum information in the total angular momentum of an electron-hole qubit. Hence, the qubit may be a singlet (S)-triplet (T) two-level qubit that physically comprises of two semiconductor islands with a tunnel junction in between. In other words, the qubit may be in a singlet (0,2) or triplet (1,1) state. Thus, the first qubit comprises the first computing semiconductor island and the first readout semiconductor island having a tunnel junction in between. The second qubit comprises the second computing semiconductor island and the second readout semiconductor island with a tunnel-junction in between. A qubit according to the present invention, comprising physical semiconductor islands, has less cross talk than qubits defined by 2-dimensional electron gas. It should be realized that the spin qubit transistor may comprise more than two qubits. Thus, the spin qubit transistor may comprise two, five, ten, one hundred or thousands of qubits. More than two qubits may be called quantum dits or qudits. The fidelity is improved when using quantum dits. It is an advantage of the present inventive concept that the number of qubits is scalable.

The qubit can be described as an electromagnetic resonator, with a resonant frequency $\omega_{01} = (E_1 - E_0)/\hbar$ associated with typically a high-quality-factor better than $10^{16}$. Resonant driving of a qubit causes sinusoidal oscillations of the probabilities $|\alpha_0|^2$ and $|\alpha_1|^2$ (where $\alpha_0$ and $\alpha_1$ are the coefficients of the superposition of two quantum states $|0\rangle$ back to $|1\rangle$) in time which are called Rabi oscillations. Resonance occurs when the frequency of the oscillating field is equal to the difference in energy between the Zeeman energy levels for the qubit. The qubit has a spontaneous transition time from the quantum states $|S\rangle$ back to $|T\rangle$.

Semiconductor islands according to the present invention can be regarded as artificial atoms of an ideal isolated quantum mechanical one-level system. Such is possible due to the fact that the semiconductor islands are formed by strain-relaxation during e.g. Metalorganic vapor phase epitaxy (MOVPE). The inventor has realized that in particular double semiconductor islands according to the present invention can be configured to behave as a two-level quantum Singlet-Triplet system with the energy difference $\Delta E >> k_B T$. At room temperature $k_B T$ is 0.0258 eV. With this, it is possible to drive the qubits fast. In particular, this does not excite the qubit to a third or fourth quantum state. The size of the semiconductor islands may be tuned for excited states with $\Delta E >> kT$. The inventor has realized that the double semiconductor islands according to the present invention are advantageous for the computational entangled state of a quantum computer using electron-hole spin qubits.

A strong spin-orbit coupling enhances the quantization of total angular momentum. The spin-orbit coupling in the present invention is the interaction of a magnetic field that arises e.g. from the orbiting of the nucleus around an unpaired electron creating a ring of current. This gives rise to a magnetic field. The energy contribution from spin-orbit coupling that gives an energy shift, $E_{so} \sim Z^4$, of the quantum state depends on the size of the nuclei. Larger atoms have larger atomic numbers, Z, and the magnetic field from the nucleus is typically larger with Z from relativistic effects, with a larger degree of spin-orbit coupling.

According to the invention, it is advantageous to use a wide band gap semiconductor. Thus, InN may be a good choice as the band gap of the semiconductor islands may be chosen as to be the highest for a potential energy well with GaN for an electron-hole. By this, the spin-orbit coupling of the semiconductor island reaches its maximum value for an infinite potential well height, (Scientific Reports, 2018, 8:7400, DOI:10.1038/s41598-018-25692-2).

The single heavy electron-hole in the semiconductor island populate the ground state, whereas the energy difference between the ground state and the excited states becomes larger and more separated according to the Schrödinger equation. Using holes as charge carrier of the semiconductor decreases the error rates compared to using electrons as charge carrier. The small size of the semiconductor island is such that excitation to higher levels than the Zeeman splitting can be ignored. Coulomb blockade provides a single positive charge or electron-hole on each of the semiconductor islands. The self-capacitance of the semiconductor island to be charged with a single positive charge +e becomes $C = \dfrac{e^2}{\Delta E}$ according to theory of Coulomb blockade, which in this case can be determined from the magnetic field strength $B_0$.

The symmetry of the electron-hole ground state wave function is $\pi$-symmetry (i.e. not $\sigma$-symmetry) with spin quantum number of 3/2. Electron qubits have the drawback of a trade-off between creating qubits with long decoherence time with slow gate times, or short decoherence times with fastest possible gate time. Electron qubits require a weak spin-orbit coupling in order to provide a long decoherence time. Electron-hole qubits behave differently than electron qubits in that a higher driving speed and high spin-orbit coupling provides longer decoherence times. Thus, it is an advantage of the present invention that it uses confined electron-holes. (Quantum Information (2021) 7:54 ; https://doi.org/10.1038/s41534-021-00386-2).

The base layer may comprise an alloy of AlGaN. The base layer may comprise Al(y)Ga(1-y)N, where y > 0 or where y = 0. The base layer may comprise an alloy of InGaN. The base layer may comprise In(z)Ga(1-z)N, where z > 0 or where z = 0. The base layer may be arranged below each individual semiconductor island, having a lateral dispersion only relating to a single semiconductor island. The base layer may be arranged under more than one semiconductor island. Thus, the base layer may be arranged under a pair of semiconductor islands configured into a qubit. The base layer may be arranged under more than one qubit. The base layer is configured such that it forms a heterojunction with the semiconductor islands. Thus, there is a strain in the surface between the base layer and the semiconductor island. The base layer may be a monolayer. The base layer may be several monolayers arranged on top of each other.

The computing semiconductor island is defined as a physical island. It should be understood that by physical it is meant that it has a miniaturized size at the nanoscale causing each of said semiconductor islands to exhibit 3-dimensional quantum confinement of a single electron-hole. Thus, the semiconductor islands are grown physically and not held together by electrostatic means. The computing semiconductor island is configured for a single electron-hole. Thus, it is configured to have one single electron-hole as charge carrier.

The readout semiconductor island is defined as a physical island. It should be understood that by physical it is meant that it has a size causing each of said semiconductor islands to exhibit 3-dimensional quantum confinement of a single electron-hole. Thus, the semiconductor islands are grown physically and not held together by electrostatic means. The readout semiconductor island is configured for a single electron-hole. Thus, it is configured to have one single electron-hole as charge carrier.

The semiconductor islands could be interpreted as a "quantum dot". Thus, the semiconductor island may be configured as a quantum dot to exhibit 3-dimensional quantum confinement of a single electron-hole.

Spin-blockade is used to configure a non-interacting state between the respective computing semiconductor island and the respective readout semiconductor island of one qubit. The Zeeman effect is used for splitting an electron-hole ground state with a magnetic field strength $B_0$ in order to configure a deterministic excited state with an energy difference $\Delta E$ i.e. that is known beforehand based on the magnetic field strength. Barriers between the plurality of readout semiconductor islands may be significantly high to prevent cross-talk of the readout. The respective readout semiconductor island with a respective second and fourth gate may be used for readout of the quantum state, (0,2) or (1,1), of the respective computing semiconductor island.

In one embodiment, the compute semiconductor island and readout semiconductor island may be cubic that is confined by an infinite potential energy well in three dimensions. Hence, according to the Schrödinger equation, the wavefunction solutions are eigenfunctions,

$$\psi_{n_x,n_y,n_z}(x, y, z) = A_x A_y A_z \sin \frac{n_x \pi x}{a} \sin \frac{n_y \pi x}{a} \sin \frac{n_z \pi x}{a}$$

with energy levels $E_{n_x,n_y,n_z} = \dfrac{\hbar \pi^2}{(2 m_h a^2)\left(n_x{}^2 + n_y{}^2 + n_z{}^2\right)}$ where $E_n$ is the energy of the quantum state, $n_x$, $n_y$, $n_z$ are quantum numbers, $m_h$ is the mass of an electron-hole and $a$ is the cubic width of the potential energy well. Thus the ground state energy $E_1$ for a GaN semiconductor island is given by the Schrödinger equation.

However, it should be understood that the potential energy well is not infinite. The GaN semiconductor island may be a cube of width $2b$ surrounded by AlGaN with the potential energy barrier $V_0$. (In practice the GaN semiconductor island may be grown on $Al_{0.20}Ga_{0.80}N$ and overgrown by the same.) The band gap of the AlGaN alloy composition is given by the expression $E_g(Al_xGa_{1-x}N) = xE_g(AlN) + (1 - x)E_g(GaN)$. Thus, the barrier height is $V_0 = E_g(Al_xGa_{1-x}N) - E_g(GaN)$. Instead, given by the potential energy well of width $2b$ in one dimension, the solution to the even parity energy levels $E_n$, are given by the expression:

$$\tan\left(\sqrt{\frac{2mb^2(E + V_0)}{\hbar^2}}\right) =$$

$$= \sqrt{\frac{-E}{E + V_0}}$$

and the solution to the odd parity energy levels $E_n$, are given by the expression:

$$\tan\left(\sqrt{\frac{2mb^2(E + V_0)}{\hbar^2}}\right) =$$

$$= -\sqrt{\frac{E + V_0}{-E}}$$

Negative values of the energy are bound states for the electron-holes. For an AlN-composition of 7.8%, the potential energy barrier height may be 0.2 eV as provided by the AlGaN alloy and the cubic width of the GaN semiconductor island may be 2 nm giving a ground state of -0.06 eV with even parity. The entanglement between compute semiconductor islands are associated with a tunneling or transmission probability which may be configured by the surrounding AlGaN alloy. The surrounding AlGaN alloy may hence be 1 nm thick. Thus the potential energy barrier $V_0$, may be 0.2 eV for a 1 nm thick $Al_{0.08}Ga_{0.92}N$ surrounding the GaN semiconductor island as a shell layer. The transmission probability $T$, is given by the expression $T \approx \left( -4b \sqrt{\frac{2m_h(V_0 - E)}{\hbar}} \right)$. The transmission probability may be configured to be 1% at the ground state

energy $V_0 - E_1 < 0.21$ eV. A transmission probability of 80% occurs very close to the top of the finite potential energy barrier i.e. at ~0.5 meV from its top. The transmission probability may be increased by applying a bias to the barrier electrode and thereby lowering the potential energy barrier between compute semiconductor islands. The tunneling probability between compute semiconductor islands and readout semiconductor islands may similarly be configured to be 1% in the ground state by having the shell layer surrounding the GaN semiconductor island to be $Al_{0.08}Ga_{0.92}N$. A fractional occupancy e.g 99% of the quantum states $|S\rangle$ back to $|T\rangle$ may be sufficient to correlate the electron-holes for providing an entangled quantum state between qubits.

In one embodiment, the spin qubit transistor may comprise barrier electrodes arranged in between and above compute semiconductor islands and a readout semiconductor islands in order to reduce the effective potential energy barrier height.

The source is arranged in ohmic contact through the supporting material to the first qubit.

The electrical contact between the source terminal and the first computing semiconductor island, via the supporting material, may be a tunnel contact.

The drain is arranged in ohmic contact through the supporting material to the second qubit.

The electrical contact between the drain terminal and the second computing semiconductor island, via the supporting material, may be a tunnel contact.

The effect of the transistor is the transfer of one hole from source to drain with a measurable average current.

The first and third gate terminals are configured to modulate the respective first and second computing semiconductor islands. Thus, the first and third gate terminals are configured to change the quantum state of the computing semiconductor island. Modulation by the first and third gate leads to rotation of the spin of the first and second computing quantum dot, respectively. The effect of the transistor is the transfer of one hole from source to drain with a measurable average current. Modulation applied to the first and third gate is in order to flip the total angular momentum from $|T\rangle$ to $|S\rangle$. This spin rotation result in removing the restraint of spin blockade. Therefore, an electron-hole can tunnel from the first computing semiconductor island to the second computing semiconductor island. The resulting (0,2) state decays by emitting an electron-hole into the drain and a hole from the source is successively fed back to the first computing semiconductor island restoring the initial spin blockade in the (1,1) charge configuration.

The first and third gate are arranged on top of the first and second computing semiconductor island. By on top, it should be realized that the first and third gate are arranged on the supporting material at a position being related to the position of the first and second computing semiconductor islands, respectively. Thus, the first gate is arranged such that it can modulate the first computing semiconductor island. The third gate is arranged such that it can modulate the second computing semiconductor island.

The first and third gate are configured to modulate the respective semiconductor island. Under resonant microwave modulation, the qubit state undergoes so-called Rabi oscillations, where the probabilities $|\alpha_0|^2$ and $|\alpha_1|^2$ evolve sinusoidally in time. Consider a semiconductor island with energy splitting $\Delta E$ between $E_1$ and $E_2$. Apply energy as a

perturbation at frequency $\omega_{01} = \frac{\Delta E}{\hbar} = \frac{(E)_1 - E_0}{\hbar} = 2\pi\gamma_e |B_0|$ by microwave modulation applied to the first or third gate. For example, if the quantum state is |T> in the respective computing semiconductor island and applying the perturbation by microwave power for short time, this develop a small amplitude to be in |S>. If continued power is applied the quantum state can be pumped entirely into |S> which is referred to as a $\pi$-pulse. According to the invention, this operation flips the respective readout semiconductor island. The readout of the first and second readout transistor island is performed by the second and fourth gate. It is widely understood that quantum computations can be realized using a combination of CNOT quantum gates and single qubit rotations CROT. The CNOT gate operates on a quantum register consisting of two qubits. The classical computational analog of the CNOT gate is a reversible XOR gate. The controlled CNOT-gate flips the readout semiconductor island only if the respective computing transistor island is in state $|S\rangle$ as was described above. Similarly, the CROT gate is equivalent to a CNOT gate except for a $\pi/2$ rotation of the spin around the z-axis.

The supporting material is embedding each of the semiconductor islands. The supporting material may be a material configured for being charge carrier for electron-holes. Thus, the supporting material may be a p-doped material or in some embodiments p-doped GaN. The supporting material may be a dielectric material. The supporting material may be configured for heavy electron-holes. The heavy-hole state is ideal for a qubit as the total angular momentum of different qubits can be coupled at large distance by tunneling using a linear or 2D array of semiconductor islands. The electron-hole spin points in the same direction as the orbital angular momentum which in quantum mechanics is measurable by the total

angular momentum operator $\mathbf{J}^2$. According to the invention a single heavy electron-hole quantum state may be configured by separation of a light hole sub-bands from the heavy electron-hole sub-band providing a pure heavy electron-hole state, where the lowest energy state at k=0 of the wave vector is a heavy electron-hole quantum state. The heavy electron-hole quantum state may be configured by the physical size of the semiconductor island e.g. 1-10 nm and straining GaN by an underlayer of pAl(y)Ga(1-y)N as a hole reservoir or InN by an under layer of p-In(Z)Ga(1-z)N as a hole reservoir. The semiconductor islands may be configured for a single heavy electron-hole state i.e. without an external magnetic field. Such may be provided by larger confinement and therefore result in longer hole spin-relaxation times.

According to electric dipole spin resonance (EDSR) the effective mass $m^\wedge_*$ and g-factors can be estimated as,

$$m^* = \frac{\hbar^2 E_g}{P^2} \text{ and } |g| \approx \frac{m_0 P^2}{\hbar^2 E_g}.$$ The g-factors of InAs/GaAs quantum dots is described in G. Medeiros-Ribeiro et al. Appl.

Phys. A (2003) as $g = 2 - \frac{2E_p \Delta}{3E_g(E_g+\Delta)}$. The g-factor approaches 1,9 for both bulk InN and GaN. Hence, it is advantageous according to the invention that the quantum dots are defined by a heterojunction of aluminium gallium nitride (AlGaN), and gallium nitride (GaN). The size of the quantum dots and the strain is used to configure the Rabi frequency.

By unique resonance frequency it should be realized that each of the computing semiconductor islands has a unique frequency. The frequency of one computing semiconductor island is not shared with any other computing semiconductor island or with any readout semiconductor island. It should be realized that two compute semiconductor islands may have the same frequency if they are separated by a distance such that they do not disrupt each other.

Each semiconductor island may comprise an Al(x)Ga(1-x)N alloy, where 1 > x > 0. Each computing semiconductor island may comprise of a unique Al(x)Ga(1-x)N alloy. Thus, each computing semiconductor island may have a unique Al(x)Ga(1-x)N not shared with any other semiconductor island. The Al(x)Ga(1-x)N alloy is configured to give the semiconductor islands their frequency. Thus, a unique Al(x)Ga(1-x)N alloy will achieving computing semiconductor islands having said unique resonance frequency. The base layer may comprise Al(y)Ga(1-y)N, where 1 > y ≥ 0. Thus, the base layer may be GaN or any alloy of Al(y)Ga(1-y)N.

Each semiconductor island may comprise an In(z)Ga(1-z)N alloy, where 1 > z > 0. Each computing semiconductor island may comprise of a unique In(z)Ga(1-z)N alloy. Thus, each computing semiconductor island may have a unique In(z)Ga(1-z)N not shared with any other semiconductor island. The In(z)Ga(1-z)N alloy is configured to give the semiconductor islands their frequency. Thus, a unique In(z)Ga(1-z)N alloy will achieving computing semiconductor islands having said unique resonance frequency. The base layer may comprise In(z)Ga(1-z)N, where 1 > z ≥ 0. Thus, the base layer may be InN or any alloy of In(z)Ga(1-z)N.

Each semiconductor island may comprise a lower region comprising an Al(x)Ga(1-x)N alloy, and an upper region comprising GaN. The base layer may be GaN, wherein the heterojunction is formed at an interface of the lower region and the base layer.

Each semiconductor island may comprise a lower region comprising an In(z)Ga(1-z)N alloy, and an upper region comprising InN. The base layer may be InN, wherein the heterojunction is formed at an interface of the lower region and the base layer.

Each semiconductor island may have a unique size, thereby achieving computing semiconductor islands having said unique resonance frequency. Thus, the size of the semiconductor islands may be decisive of the frequency.

The semiconductor islands may be formed by epitaxial growth and exhibit 3-dimensional quantum confinement. The strain of the semiconductor islands may be configured during growth of GaN semiconductor islands e.g. by selective area growth. The distance between quantum dots may be controlled by nanosize holes in a hard mask such as $SiO_2$, $Al_2O_3$ or $Si_3N_4$ using selective area growth. Thus, the epitaxial growth may be selective area growth. This causes semiconductor islands to form during epitaxial growth with pattern control with a short but significant abruptness of the growth on the order of ~10s. A 0-dimensional hole gas (0DHG) forms within the quantum dot. The thickness of the AlGaN underlayer may be significantly thick to reduce Coulomb interaction between electrons and holes. In another embodiment of the invention AlGaN semiconductor islands are grown on GaN. The document Birudavolu, S. et al, Selective area growth of InAs quantum dots formed on a patterned GaAs substrate. Applied Physics Letters,2004, 85, 2337-2339, describes selective area growth for the formation of quantum dots . Undoped GaN semiconductor islands that may be formed on InGaN becomes negatively polarized due to strain. The semiconductor islands may be formed by Stranski-Krastanov growth.

Each of the semiconductor islands may consist of a material having a wurtzite crystal structure. Gallium nitride and its alloys of In(z)Ga(1-z)N and of Al(x)Ga(1-x)N have wurtzite crystal structure that is non-centrosymmetric. Hence, it lacks inversion symmetry. Electron qubits in these alloys are subject to piezoelectric phonons that cause decoherence. Broken symmetry or inversion asymmetry can be invoked by straining the heterostructure quantum dots, causing splitting of the valence band in light holes and heavy electron-holes. The gate may be pulsed with a microwave modulation that reduces the tunneling barrier between two neighboring quantum dots. The coherence time of the quantum state should be

longer than $\dfrac{\hbar}{\Delta E}$ .

The respective computing semiconductor island and readout semiconductor island is arranged with a distance in the range of 3-10 nm therebetween. The semiconductor islands may be arranged in a plane parallel to the base layer. The semiconductor islands may be separated from each other in said plane parallel to the base layer. The semiconductor islands may be laterally disposed with respect to each other.

The respective computing semiconductor islands and readout semiconductor islands of each qubit may be arranged and positioned such that an electron hole can be excited from the compute semiconductor island to the readout semiconductor island in each qubit.

The first qubit and the second qubit may be arranged and positioned to be entangled. The first computing semiconductor island and the second computing semiconductor island may be arranged and positioned to be entangled. The first qubit and the second qubit may be arranged such that the spin of the electron hole of the respective computing semiconductor islands are entangled. It should be understood that in embodiments comprising more than two qubits, all qubits are entangled. The inventor has realized that the double semiconductor islands, i.e. the qubits, formed in In(1-z)Ga(z)N and its alloys or in Al(1-x)Ga(x)N and its alloys are advantageous for the computational entangled state of a quantum computer using electron-hole spin qubits.

The first gate terminal may be configured to excite an electron hole to cause the first qubit to transition from a singlet state to a triplet state. The first gate terminal may be configured to electrostatically excite said electron hole to cause the first qubit to transition from said singlet state to said triplet state. The first gate may be configured for microwave modulation of the spin state of the first computing semiconductor island of the first qubit. The first gate may have ohmic contact with the base layer. The third gate terminal is configured to excite an electron hole to cause the first qubit to transition from a singlet state to a triplet state. The third gate terminal is configured to electrostatically excite said electron hole to cause the second qubit to move from said singlet state to said triplet state. The third gate may be configured for microwave modulation of the spin state of the second computing semiconductor island of the first qubit. The third gate may have ohmic contact with the base layer. The coherence time of the quantum state should be longer than $\hbar/\Delta E$. The gate may be pulsed with a microwave modulation that reduces the tunneling barrier between two neighboring compute semiconductor islands. Microwave modulation applied to the first and third gate are used to rotate the spin of quantum dots i.e. a radio frequency electric field may be applied to the electrodes. The microwave modulation may be a burst of time $\tau\_burst$. A flipping between the $|S\rangle$ state to the $|T\rangle$ state can be accomplished by controlling the envelope amplitude and pulse duration of a microwave resonator gate where a rotation of the quantum state vector occurs of the electron-hole when supplied with energy according to the photoelectric effect, $E = \hbar\omega$.

The spin qubit transistor may further comprise a control electrode arrangement configured to modify a tunneling property between the first computing semiconductor island and the second computing semiconductor island. Alternatively, the spin qubit transistor may further comprise a control electrode arrangement configured to modify a tunneling probability between the first computing semiconductor island and the second computing semiconductor island. The control electrode arrangement may be arranged in the same plane, parallel to the plane of the semiconductor island, where the first, second, third and fourth gates are arranged. The control electrode arrangement may be arranged between the first and the third gate. The control electrode arrangement may be configured to modify a region of material between the first computing semiconductor island and the second computing semiconductor island. The control electrode arrangement may be configured to reduce a potential barrier between the compute semiconductor islands. The region of material may be of the same material as the supporting material. The region may be a barrier region of a different material. The region may be a barrier region being n-doped.

The spin qubit transistor may further comprise a control electrode arrangement configured to modify a tunneling property between the first computing semiconductor island and the first readout semiconductor island. The control electrode arrangement may be arranged between the first gate and the second gate. The spin qubit transistor may further comprise a control electrode arrangement configured to modify a tunneling property between the second computing semiconductor island and the second readout semiconductor island The control electrode arrangement may be arranged between the third gate and the fourth gate. Alternatively, the spin qubit transistor may further comprise a control electrode arrangement configured to modify a tunneling probability between the first computing semiconductor island and the first readout semiconductor island. Alternatively, the spin qubit transistor may further comprise a control electrode arrangement configured to modify a tunneling probability between the second computing semiconductor island and the second readout semiconductor island. The control electrode arrangement may be arranged in the same plane, parallel to the plane of the semiconductor island, where the first, second, third and fourth gates are arranged. The control electrode arrangement may be configured to modify a region of material between the first computing semiconductor island and the first readout semiconductor island. The control electrode arrangement may be configured to modify a region of material between the second computing semiconductor island and the second readout semiconductor island. The control electrode arrangement may be configured to reduce a potential barrier between the respective compute semiconductor island and readout semiconductor island. The region of material may be of the same material as the supporting material.

The region may be a barrier region of a different material. The region may be a barrier region being n-doped.

The supporting material may be p-doped GaN. Thus, the supporting material may act as a hole reservoir for the semiconductor islands.

The supporting material may be a dielectric material.

The band structure of the semiconductor islands, including compute and readout semiconductor islands, are configured with heavy electron-holes at the origin in k-space by the composition of the base layer.

Another aspect of the present inventive concept is a method for forming an electron-hole spin qubit transistor comprising the steps of:

forming a hard mask layer on a base layer;

forming a first plurality of nano size cavities in the hard mask layer;

exposing the base layer to semiconductor reactive species, thereby forming a plurality of first compute semiconductor islands in said first plurality of nano size cavities;

forming a second plurality of nano size cavities in the hard mask layer;

exposing the base layer to semiconductor reactive species, thereby forming a plurality of second compute semiconductor islands in said second plurality of nano size cavities;

forming a third plurality of nano size cavities in the hard mask layer;

exposing the base layer to semiconductor reactive species, thereby forming, in said third plurality of nano size cavities:

a plurality of first readout semiconductor islands, each of said plurality of first readout semiconductor islands being arranged within a distance in the range of 3-10 nm from each of said plurality of first compute semiconductor islands, and

a plurality of second readout semiconductor islands, each of said plurality of second readout semiconductor islands being arranged within a distance in the range of 3-10 nm from each of said plurality of second compute semiconductor islands;

removing the hard mask layer by wet etching or plasma etching, and embedding the formed plurality of first compute semiconductor islands, the formed plurality of second compute semiconductor islands, and the plurality of first and second readout semiconductor islands in a supporting material laterally overgrown over the semiconductor islands

forming at least one source terminal being in electrical contact with the plurality of first computing semiconductor islands via the supporting material;

forming at least one drain terminal being in electrical contact with the plurality of second computing semiconductor islands via the supporting material;

forming a plurality of first gate terminals arranged over each of the plurality of first computing semiconductor islands, the plurality of first gate terminals being configured for microwave modulation of the spin state of each of the plurality of first computing semiconductor islands;

forming a plurality of second gate terminals arranged over each of the plurality of first readout semiconductor islands, the plurality of second gate terminals being configured for readout of a state of each of the plurality of first readout semiconductor islands;

forming a plurality of third gate terminals arranged over each of the plurality of second computing semiconductor islands, the plurality of third gate terminals being configured for microwave modulation of the spin state of each of the plurality of second computing semiconductor islands;

forming a plurality of fourth gate terminals arranged over each of the second readout semiconductor islands, the plurality of fourth gate terminals being configured for readout of a state of each of the plurality of second readout semiconductor islands.

It should be realized that there may be more optional steps between the steps of the method.

The method provides with a method for forming a spin qubit transistor. The method allows for forming 3-dimensional semiconductor islands, such as physically determined semiconductor islands. The method allows for forming compute semiconductor islands of unique alloys, giving them unique frequency.

The distance between the first compute semiconductor islands may be 5-15 nm. The distance between the second compute semiconductor islands may be 5-15 nm. The semiconductor reactive species forming the first compute semiconductor islands may be a different alloy than the semiconductor reactive species forming the second compute semiconductor islands.

The method may comprise additional steps of forming of hard mask layers, such that they cover the first and second semiconductor islands respectively before forming the second and third plurality of nano size cavities.

The plurality of first compute semiconductor islands and the plurality of second compute semiconductor islands may be configured for a lattice-mismatch to the base layer for providing a Rabi frequency. Thus, semiconductor reactive species may for a strain with the base layer.

The plurality of first compute semiconductor islands, the plurality of second compute semiconductor island, and the plurality of readout semiconductor islands may form a matrix of qubits. Thus, the plurality of first compute semiconductor islands, the plurality of second compute semiconductor island, and the plurality of readout semiconductor islands may form a qudit. Thus, the method may be used for the production of a large size quantum computer.

The method may further comprise forming a cap layer on each of the plurality of first compute semiconductor islands and each of the plurality of second compute semiconductor islands to configure a heterostructure. Thus, the first compute semiconductor islands and the second semiconductor islands may each comprise of two alloys.

As an alternative, a third aspect of the present inventive concept is a method for forming an electron-hole spin qubit transistor comprising the steps of:

> providing a layer structure comprising a plurality of semiconductor layers stacked over each other, each of the plurality of semiconductor layers being a unique material/alloy;
>
> forming a first hard mask layer on top of the plurality of semiconductor layers;
>
> forming a first plurality of nano size cavities through first hard mask layer and extending to a first layer of said plurality of semiconductor layers at a first depth;
>
> exposing the layer structure to a first semiconductor reactive species, thereby forming a plurality of first compute semiconductor islands in said first plurality of nano size cavities;
>
> forming a second hard mask layer on top of the plurality of semiconductor layers;
>
> forming a second plurality of nano size cavities through the second hard mask layer and extending to a second layer of said plurality of semiconductor layers at a second depth;
>
> exposing the layer structure to a second semiconductor reactive species, thereby forming a plurality of second compute semiconductor islands in said second plurality of nano size cavities;
>
> forming a third hard mask layer on top of the plurality of semiconductor layers;
>
> forming a third plurality of nano size cavities through the third hard mask layer and extending to a third layer of said plurality of semiconductor layers at a third depth;
>
> exposing the layer structure to a third semiconductor reactive species, thereby forming a plurality of first and second readout semiconductor islands in said third plurality of nano size cavities;
>
> wherein the first, second, and third depths differs by at least one layer of said semiconductor layers;
>
> removing all hard mask layers by wet etching or plasma etching;
>
> embedding the formed plurality of first compute semiconductor islands, the formed plurality of second compute semiconductor islands, and the formed plurality of first and second readout semiconductor islands in a supporting material laterally overgrown over the semiconductor islands;
>
> forming at least one source terminal being in electrical contact with the plurality of first computing semiconductor islands via the supporting material;
>
> forming at least one drain terminal being in electrical contact with the plurality of second computing semiconductor islands via the supporting material;
>
> forming a plurality of first gate terminals arranged over each of the plurality of first computing semiconductor islands, the plurality of first gate terminals being configured for microwave modulation of the spin state of each of the plurality of first computing semiconductor islands;
>
> forming a plurality of second gate terminals arranged over each of the plurality of first readout semiconductor islands, the plurality of second gate terminals being configured for readout of a state of each of the plurality of first readout semiconductor islands;
>
> forming a plurality of third gate terminals arranged over each of the plurality of second computing semiconductor islands, the plurality of third gate terminals being configured for microwave modulation of the spin state of each of the plurality of second computing semiconductor islands;
>
> forming a plurality of fourth gate terminals arranged over each of the second readout semiconductor islands, the plurality of fourth gate terminals being configured for readout of a state of each of the plurality of second readout semiconductor islands.

It is to be understood that the step of removing all hard mask layers by wet etching or plasma etching may be performed as a single step, or alternatively as several steps throughout the disclosed method. Such several steps of removing a hard mask layer may be performed at various stages of the disclosed method, as will be appreciated by the person skilled in the art.

Thus, by the third aspect of the inventive concept the unique frequency of each of the compute semiconductor islands is decided by the unique depth of the semiconductor islands.

A fourth aspect of the present inventive concept is a quantum computer comprising at least one spin qubit transistor according to above. The computer may comprise a plurality of spin qubit transistors. Each of the spin qubit transistors of the quantum computer may comprise a plurality of qubits according to the above. The inventor has realized that the double semiconductor islands formed in Al(1-x)Ga(x)N or In(1-x)Ga(x)N and its alloys are advantageous for the computational entangled state of a quantum computer using electron-hole spin qubits. A qubit processor of N qubits may be used. Further parallelization with multiple N-qubit processors may be used on the same chip. The scalability of quantum computers requires long distance coupling methods between the physical realization of qubits.

A feature described in relation to one aspect may also be incorporated in other aspects, and the advantage of the feature is applicable to all aspects in which it is incorporated.

Other objectives, features and advantages of the present inventive concept will appear from the following detailed disclosure, from the attached claims as well as from the drawings.

Generally, all terms used in the claims are to be interpreted according to their ordinary meaning in the technical field, unless explicitly defined otherwise herein. Further, the use of terms "first", "second", and "third", and the like, herein do not denote any order, quantity, or importance, but rather are used to distinguish one element from another. All references to "a/an/the [element, device, component, means, step, etc]" are to be interpreted openly as referring to at least one instance of said element, device, component, means, step, etc., unless explicitly stated otherwise. The steps of any method disclosed herein do not have to be performed in the exact order disclosed, unless explicitly stated.

## Brief description of the drawings

The above, as well as additional objects, features and advantages of the present inventive concept, will be better understood through the following illustrative and non-limiting detailed description of the present inventive concept, with reference to the appended drawings, wherein:

Fig. 1 illustrates a cross sectional view of a spin qubit transistor.

Fig. 2 illustrates a cross sectional top view of a spin qubit transistor.

Fig. 3a illustrates a cross sectional side view of a spin qubit transistor.

Fig. 3b illustrates a cross sectional side view of a spin qubit transistor.

Figs. 4a illustrates a cross sectional view of a spin qubit transistor.

Figs. 4b illustrates a cross sectional view of a spin qubit transistor.

Fig. 5 illustrates a cross sectional top view of multiple spin qubit transistors, i.e. a qudit.

Fig. 6 illustrates a method for forming a spin qubit transistor.

Fig. 7a illustrates a cross sectional view of a spin qubit transistor formed by the method of Fig. 6.

Fig. 7b illustrates a cross sectional top view multiple spin qubit transistors made by the method of Fig. 6.

Fig. 8 illustrates an alternative method for forming a spin qubit transistor.

Figs. 9a and 9b illustrate a cross sectional view of a spin qubit transistor made by the method of Fig. 8.

Figs. 10a illustrate the triplet state of a qubit.

Figs. 10b illustrate the singlet state of a qubit.

The figures are not necessarily to scale, and generally only show parts that are necessary in order to elucidate the inventive concept, wherein other parts may be omitted or merely suggested.

## Detailed description

In cooperation with attached drawings, the technical contents and detailed description of the present invention are described thereinafter according to preferable embodiments, being not used to limit the claimed scope. This invention may be embodied in many different forms and should not be construed as limited to the embodiments set forth herein;

rather, these embodiments are provided for thoroughness and completeness, and fully convey the scope of the invention to the skilled person.

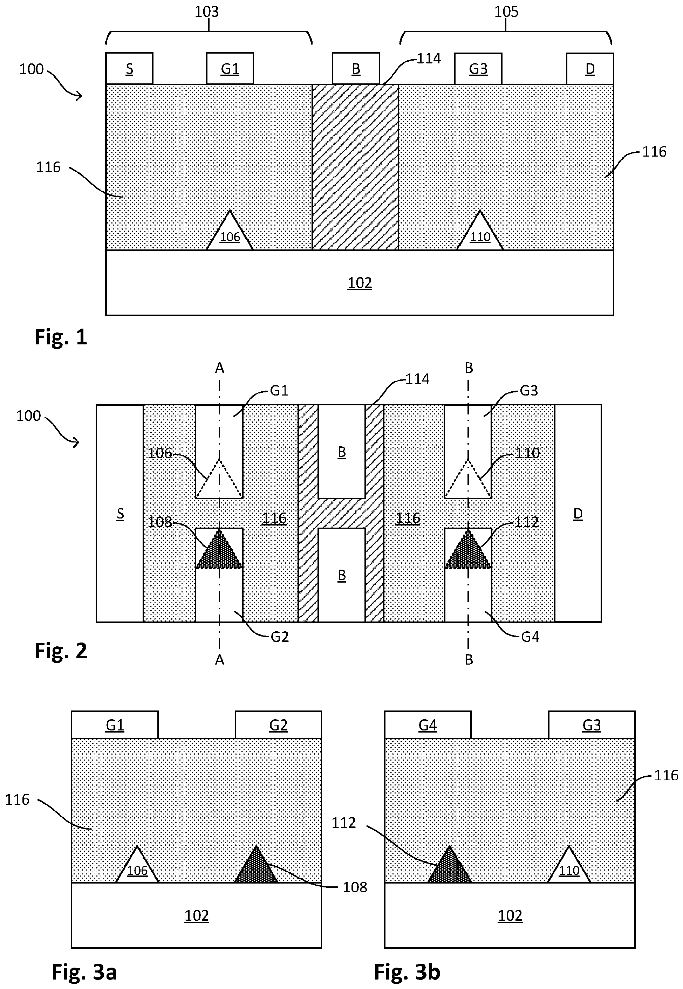

Fig. 1 illustrates a cross sectional view of an electron-hole spin qubit transistor 100. The illustrated spin qubit transistor 100 comprises a first qubit 103 and a second qubit 105. The first qubit 103 comprises a first computing semiconductor island 106. The first qubit 103 further comprises a first readout semiconductor island 108 (not shown in figure 1). The second qubit 105 comprises a second semiconductor island 110. The second qubit 105 further comprises a second readout semiconductor island 112 (not shown in figure 1). The first computing semiconductor island 106 and the second computing semiconductor island 110 are configured to each have a unique resonance frequency.

The semiconductor islands 106, 108, 110, 112 has a size causing each of said semiconductor islands 106, 108, 110, 112 to exhibit 3-dimensional quantum confinement of a single electron hole. Thus, each semiconductor island has a size corresponding to only one electron hole. The semiconductor islands 106, 108, 110, 112 has dimensions of 4 nm. The semiconductor islands 106, 108, 110, 112 may comprise an Al(x)Ga(1-x)N alloy, where 1 > x > 0. Each of the computing semiconductor islands 106, 108 may comprise a unique Al(x)Ga(1-x)N alloy. Each semiconductor islands 106, 108 may comprise an In(z)Ga(1-z)N alloy, where 1 > z > 0. Each computing semiconductor islands 106, 108 may comprise of a unique In(z)Ga(1-z)N alloy. Thus, each computing semiconductor islands 106, 108 may have a unique In(z)Ga(1-z)N alloy. Thereby, each computing semiconductor island 106, 108 achieves said unique resonance frequency. The first computing semiconductor island 106 is entangled to the second computing semiconductor island 110.

The semiconductor islands 106, 108, 110, 112 are epitaxially grown on top of a base layer 102. The semiconductor islands 106, 108, 110, 112 have an axial direction normal to the base layer 102. Each of said semiconductor islands 106, 108, 110, 112 forms a heterojunction with the base layer 102. The base layer 102 is illustrated as if it in one single piece underlines the entire spin qubit transistor 100. However, the base layer 102 may be arranged only below each semiconductor island 106, 108, 110, 112. The epitaxial growth of the semiconductor islands 106, 108, 110, 112 on the base layer 102 creates a strain between the materials needed to create an electron hole. The base layer 102 may comprise Al(y)Ga(1-y)N, where 1 > y ≥ 0. The base layer 102 may comprise In(z)Ga(1-z)N, where 1 > z ≥ 0.

The spin qubit transistor 100 further comprises a supporting material 116. The supporting material 116 is arranged on top of and embedding each of the semiconductor islands 106, 108, 110, 112. The supporting material may be p-doped, thereby acting as a hole reservoir for the semiconductor islands 106, 108, 110, 112. In addition, the supporting material 116 may comprise Al(y)Ga(1-y)N. The supporting material 116 may be dielectric.

As illustrated in fig. 1, the spin qubit transistor 100 further comprises a source terminal S. The source terminal S is in electrical contact with the first computing semiconductor island 106 via the supporting material 116. The electrical contact may be a tunnel contact. Further, the spin qubit transistor 100 comprises a drain terminal D. The drain terminal D is in electrical contact with the second computing semiconductor island 110 via the supporting material 116. The electrical contact may be a tunnel contact. The effect of the transistor is the transfer of one hole from source S to drain D with a measurable average current.

The spin qubit transistor 100 further comprises a first gate terminal G1, a second gate terminal G2 (not shown in Fig. 1), a third gate terminal G3 and a fourth gate terminal G4 (not show in Fig. 1). The first gate terminal G1 is arranged over the first computing semiconductor island 106. The first gate terminal G1 is configured for microwave modulation of the spin state of the first computing semiconductor island 106. The second gate terminal G2 arranged over the first readout semiconductor island 108. The second gate terminal G2 is configured for readout of a quantum state of the first readout semiconductor island 108. The third gate terminal G3 is arranged over the second computing semiconductor island 110. The third gate terminal G3 is configured for microwave modulation of the spin state of the second computing semiconductor island 110. The fourth gate terminal G4 is arranged over the second readout semiconductor island 112. The fourth gate terminal G4 is configured for readout of a state of the second readout semiconductor island 112.

The first gate terminal G1 may be configured to excite an electron hole to cause the first qubit 103 to transition from a singlet state to a triplet state. The state of the first qubit 103 is read by the second gate G2. The electron hole may tunnel to the second qubit 105. An electron hole from the second qubit 105 may tunnel to the drain.

The spin qubit transistor may further comprise a control electrode arrangement B. The control electrode arrangement B is configured to modify a tunneling property between the first computing semiconductor island 106 and the second computing semiconductor island 110. Alternatively, the control electrode arrangement B is configured to modify a tunneling probability between the first computing semiconductor island 106 and the second computing semiconductor island 110 The control electrode arrangement B may be arranged between the first G1 and the third gate G3. The control electrode arrangement B may be configured to modify a region of material 114 between the first computing semiconductor island 106 and the second computing semiconductor island 110. The region of material 114 may be of the same material as the supporting material 116. The region of material 114 may be a barrier region of a different material. The region of material 114 may be a barrier region being n-doped.

Referring now to fig. 2, the spin qubit transistor 100 is viewed cross sectionally from above. Many features are common with the one of Fig. 1 and are for means of simplicity not repeated.

In Fig 2, the arrangement of the first readout semiconductor island 108 in relation to the first computing semiconductor island 106 can be seen. The first computing semiconductor island 106 and the first readout semiconductor island 108 are laterally disposed along the axis A. The distance between the first computing semiconductor island 106 and the first readout semiconductor island 108 is 3-10 nm. The same arrangement is valid for the second semiconductor island 110 and the second readout semiconductor island 112, which are laterally disposed along the axis B. The distance between the axis A and the axis B may vary between 10 and 50 nm.

Viewed from above, it can be understood that the first, second, third and fourth gate G1, G2, G3, G4 are arranged on top of the respective first computing semiconductor island 106, first readout semiconductor island 108, second computing semiconductor island 110 and second readout semiconductor island 112.

The control electrode arrangement B may be located between the first gate G1 and the third gate G3 and between the second gate G2 and the further gate G4.

Fig. 3a and Fig 3b illustrates the spin qubit transistor viewed cross sectionally from two opposite sides. Many features are common with the one of Fig. 1 and Fig. 2 and are for means of simplicity not repeated.

In Fig. 3a the arrangement of the first computing semiconductor island 106 in relation to the first gate G1, the first readout semiconductor island 108 and to the second gate G2 can be seen. The first gate G1 is arranged vertically above the first compute semiconductor island 106. The second gate G2 is arranged vertically above the first readout semiconductor island 108. In Fig. 3b the arrangement of the second computing semiconductor island 110 in relation the third gate G3, the second readout semiconductor island 112 and to the fourth gate G4 can be seen. The third gate G3 is arranged vertically above the second compute semiconductor island 110. The fourth gate G4 is arranged vertically above the second readout semiconductor island 112. The gates G1, G2, G3, G4 are electrically connected to the respective semiconductor island 106, 108, 110, 112 via the supporting material 116.

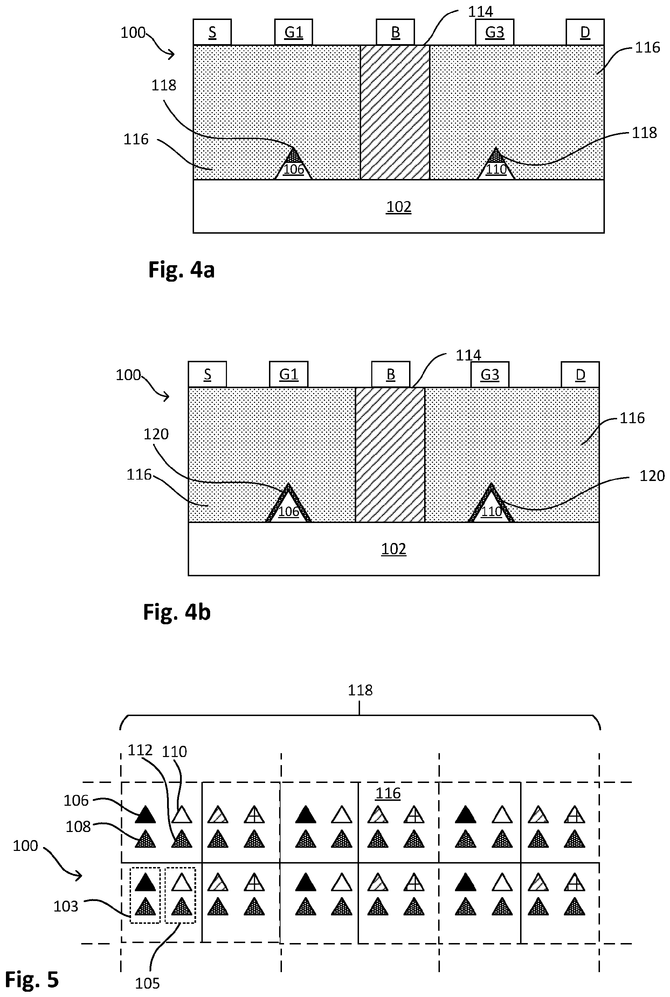

Referring now to fig. 4a and fig. 4b, the spin qubit transistor 100 is viewed cross sectionally from the side. Many features are common with the one of Fig. 1 and are for means of simplicity not repeated.

In Fig 4a. the compute semiconductor islands 106, 110 has a cap layer 120. The cap layer 120 may cover a part of the compute semiconductor island 106, 110. The cap layer 120 may comprise Al(y)Ga(1-y)N.

In Fig. 4b the compute semiconductor islands 106, 110 has a shell layer 122. The shell layer 122 may cover the entire semiconductor island 106, 110. The shell layer 122 may comprise Al(y)Ga(1-y)N.

The cap layer 120 or the shell layer 122 may also be applied to readout semiconductor islands 108, 112. The cap layer 120 or shell layer 122 as presented in Fig. 4a and Fig. 4b may be used together with any of the embodiments described herein, such as the embodiment of figure 1, 2, 3a-3b, 5, 6, 7a-7b, 8, and 9a-9b.

Now referring to Fig. 5, sixteen pairs of a first qubit 103 and a second qubit 105 forming a qudit 118 are viewed from above. The qudit 118 comprises several spin qubit transistors as described in accordance with Fig. 1-4.

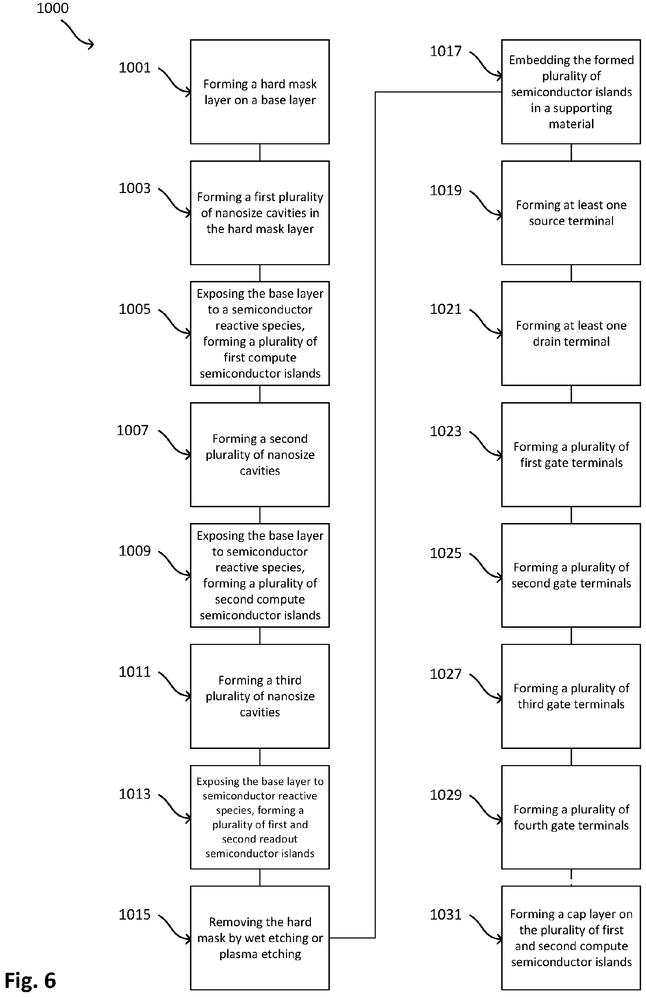

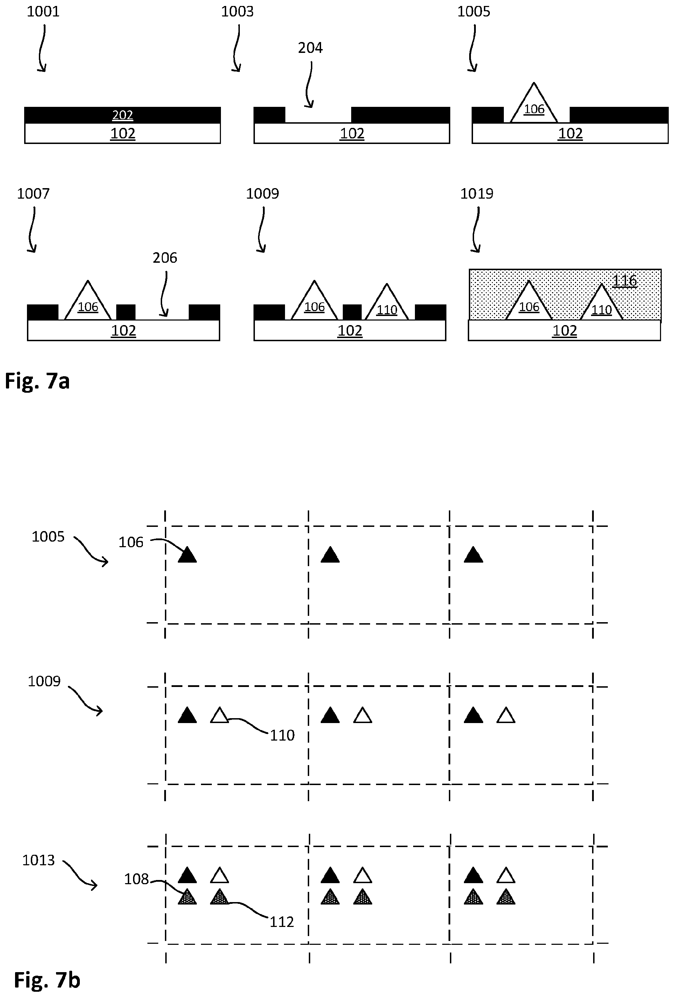

A method 1000 for forming a spin qubit transistor 100 according to the inventive concept will now be described with reference to Fig. 6, Fig. 7a and Fig. 7b. For clarity and simplicity, the method will be described in terms of 'steps'. It is emphasized that steps are not necessarily processes that are delimited in time or separate from each other, and more than one 'step' may be performed at the same time in a parallel manner.

The method 1000 for forming an electron-hole spin qubit transistor 100 comprises the steps of:

forming 1001 a hard mask layer 202 on a base layer 102;

forming 1003 a first plurality of nano size cavities 204 in the hard mask layer 202;

exposing 1005 the base layer 102 to semiconductor reactive species, thereby forming a plurality of first compute semiconductor islands 106 in said first plurality of nano size cavities 204;

forming 1007 a second plurality of nano size cavities 206 in the hard mask layer 202;

exposing 1009 the base layer 102 to semiconductor reactive species, thereby forming a plurality of second compute semiconductor islands 110 in said second plurality of nano size cavities 206;

forming 1011 a third plurality of nano size cavities 208 in the hard mask layer 202;

exposing 1013 the base layer 102 to semiconductor reactive species, thereby forming, in said third plurality of nano size cavities 208:

a plurality of first readout semiconductor islands, each of said plurality of first readout semiconductor islands being arranged within a distance in the range of 3-10 nm from each of said plurality of first compute semiconductor islands, and

a plurality of second readout semiconductor islands, each of said plurality of second readout semiconductor islands being arranged within a distance in the range of 3-10 nm from each of said plurality of second compute semiconductor islands;

removing 1015 the hard mask layer by wet etching or plasma etching, and embedding 1017 the formed plurality of first compute semiconductor islands, the formed plurality of second compute semiconductor islands, and the plurality of first and second readout semiconductor islands in a supporting material 116 laterally overgrown over the semiconductor islands

forming 1019 at least one source terminal S being in electrical contact with the plurality of first computing semiconductor islands via the supporting material 116;

forming 1021 at least one drain terminal D being in electrical contact with the plurality of second computing semiconductor islands via the supporting material 116;

forming 1023 a plurality of first gate terminals G1 arranged over each of the plurality of first computing semiconductor islands, the plurality of first gate terminals G1 being configured for microwave modulation of the spin state of each of the plurality of first computing semiconductor islands;

forming 1025 a plurality of second gate terminals G2 arranged over each of the plurality of first readout semiconductor islands, the plurality of second gate terminals G2 being configured for readout of a state of each of the plurality of first readout semiconductor islands;

forming 1027 a plurality of third gate terminals G3 arranged over each of the plurality of second computing semiconductor islands, the plurality of third gate terminals G3 being configured for microwave modulation of the spin state of each of the plurality of second computing semiconductor islands;

forming 1029 a plurality of fourth gate terminals G4 arranged over each of the second readout semiconductor islands, the plurality of fourth gate terminals G4 being configured for readout of a state of each of the plurality of second readout semiconductor islands.

During step 1001 a hard mask 202 is formed on the base layer 102. The hard mask is further during step 1003 provided with a first plurality of nano size cavities 204. The plurality of nano size cavities may be made by etching.

In step 1005 of the method 1000 a plurality of first compute semiconductor islands 106 are formed by exposing the base layer 102, through the hard mask 202, to a first semiconductor reactive species. The number of first compute semiconductor islands 106 formed may be at least 2, such as 10, 50, 100, 1000 and so on. As can be seen in Fig. 7b the plurality of first compute semiconductor islands are arranged at a distance from each other. The distance may be selected such that two of the plurality of first compute semiconductor islands having the same frequency do not disrupt or interfere with each other.

During step 1007, a second plurality of nano size cavities 206. The plurality of nano size cavities may be made by etching.

In step 1009, a plurality of second compute semiconductor islands 110 are formed by exposing the base layer 102, through the hard mask 202, to a second semiconductor reactive species. The number of second compute semiconductor islands 110 formed may be at least 2, such as 10, 50, 100, 1000 and so on. As can be seen in Fig. 7b the plurality of second compute semiconductor islands are at a distance from each other. The distance may be selected such that two of the plurality of second compute semiconductor islands having the same frequency do not disrupt or interfere with each other.

The first and second semiconductor reactive species differs from each other. The number of second compute semiconductor islands 110 equals the number of first compute semiconductor islands 106.

In step 1013 a plurality of first and second readout semiconductor islands 108, 112 are formed by exposing the base layer 102, through the hard mask 202, to a third semiconductor reactive species.

The first, second and third semiconductor reactive species differs from each other. The first and second readout semiconductor islands 108,112 may be made by two different semiconductor reactive species, respectively. If the first and second readout semiconductor islands 108, 112 are made of different semiconductor reactive species, they may be made in two different steps.

The number of first and second compute semiconductor islands 106, 110 equals the number of first and second readout semiconductor islands 108,112, respectively. The first readout semiconductor islands 108 forms a pair with the first compute semiconductor island 106. The second readout semiconductor islands 112 forms a pair with the second compute semiconductor islands 110.

The plurality of first compute semiconductor islands 106 and the plurality of second compute semiconductor islands 110 may be configured for a lattice-mismatch to the base layer 102 for providing a Rabi frequency.

The plurality of first compute semiconductor islands 106, the plurality of second compute semiconductor island 110, and the plurality of readout semiconductor islands 108, 112 form a matrix of qubits.

The method may further comprise forming 1031 a cap layer on each of the plurality of first compute semiconductor islands 106 and each of the plurality of second compute semiconductor islands 110 to configure a heterostructure.

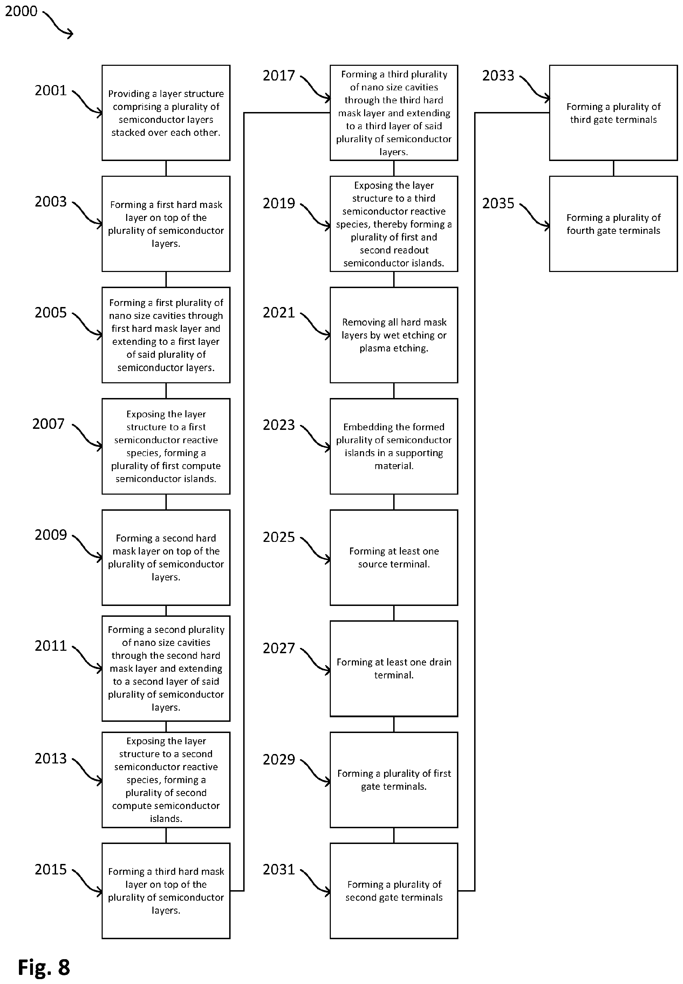

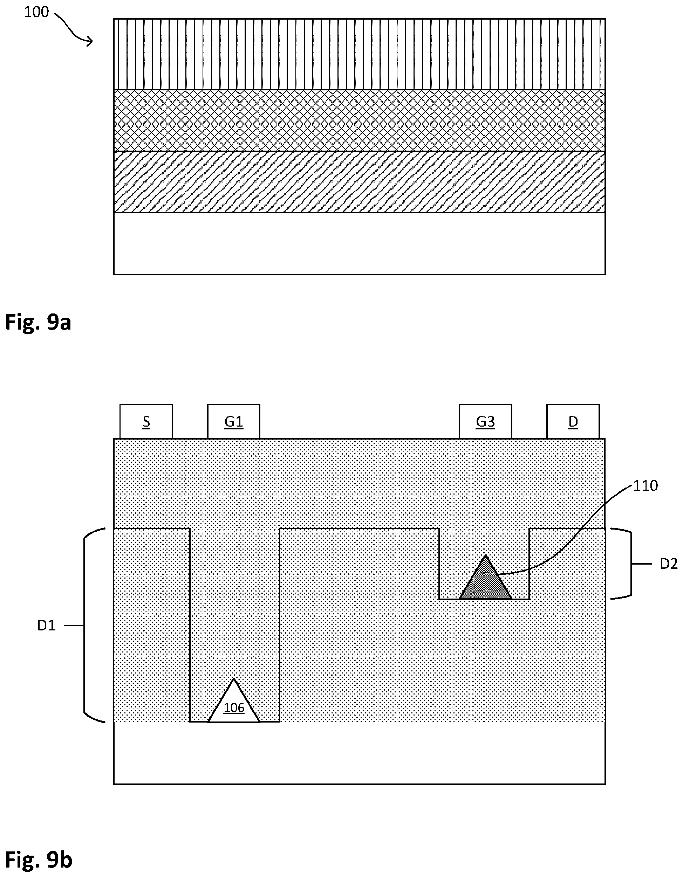

In relation to Figs. 8, 9a and 9b, an alternative method 2000, for forming an electron-hole spin qubit transistor 100 is disclosed, comprising the steps of:

providing 2001 a layer structure comprising a plurality of semiconductor layers stacked over each other, each of the plurality of semiconductor layers being a unique material/alloy;

forming 2003 a first hard mask layer on top of the plurality of semiconductor layers;

forming 2005 a first plurality of nano size cavities through first hard mask layer and extending to a first layer of said plurality of semiconductor layers at a first depth D1;

exposing 2007 the layer structure to a first semiconductor reactive species, thereby forming a plurality of first compute semiconductor islands 106 in said first plurality of nano size cavities;

forming 2009 a second hard mask layer on top of the plurality of semiconductor layers;

forming 2011 a second plurality of nano size cavities through the second hard mask layer 202b and extending to a second layer of said plurality of semiconductor layers at a second depth D2;

exposing 2013 the layer structure to a second semiconductor reactive species, thereby forming a plurality of second compute semiconductor islands 110 in said second plurality of nano size cavities;

forming 2015 a third hard mask layer on top of the plurality of semiconductor layers;

forming 2017 a third plurality of nano size cavities through the third hard mask layer 202c and extending to a third layer of said plurality of semiconductor layers at a third depth D3;

exposing 2019 the layer structure to a third semiconductor reactive species, thereby forming a plurality of first and second readout semiconductor islands 108,112 in said third plurality of nano size cavities;

wherein the first, second, and third depths D1, D2, differs by at least one layer of said semiconductor layers;

removing 2021 all hard mask layers by wet etching or plasma etching;

embedding 2023 the formed plurality of first compute semiconductor islands 106, the formed plurality of second compute semiconductor islands 110, and the formed plurality of first and second readout semiconductor islands 108, 112 in a supporting material 116 laterally overgrown over the semiconductor islands 106, 108, 110, 112;

forming 2025 at least one source terminal S being in electrical contact with the plurality of first computing semiconductor islands 106 via the supporting material 116;

forming 2027 at least one drain terminal D being in electrical contact with the plurality of second computing semiconductor islands 110 via the supporting material 116;

forming 2029 a plurality of first gate terminals G1 arranged over each of the plurality of first computing semiconductor islands 106, the plurality of first gate terminals G1 being configured for microwave modulation of the spin state of each of the plurality of first compute semiconductor islands 106;

forming 2031 a plurality of second gate terminals arranged over each of the plurality of first readout semiconductor islands 108, the plurality of second gate terminals G2 being configured for readout of a state of each of the plurality of first readout semiconductor islands 108;

forming 2033 a plurality of third gate terminals G3 arranged over each of the plurality of second computing semiconductor islands 110, the plurality of third gate terminals G3 being configured for microwave modulation of the spin state of each of the plurality of second computing semiconductor islands 110;

forming 2035 a plurality of fourth gate terminals arranged over each of the second readout semiconductor islands 112, the plurality of fourth gate terminals G4 being configured for readout of a state of each of the plurality of second readout semiconductor islands 112.

In relation to Figs. 9a and 9b, the layer structure of step 2001 is shown. Further, in the layer structure compute semiconductor islands 106, 110 are embedded. The different compute semiconductor islands are present at different depth in relation to full layers of the semiconductor layers. It should be understood that the number of layer may be more than the four depicted in Fig. 9. Moreover, it should be understood that the compute semiconductor islands may have a larger or smaller height distance between each other. In other words, as illustrated, the first compute semiconductor island 106 may be arranged at a first semiconductor layer, and the second semiconductor island 110 may be arranged at a second semiconductor layer, wherein an intermediate semiconductor layer or other layer is arranged between the first semiconductor layer and the second semiconductor layer. Such other layer may for example be an etch stop layer.

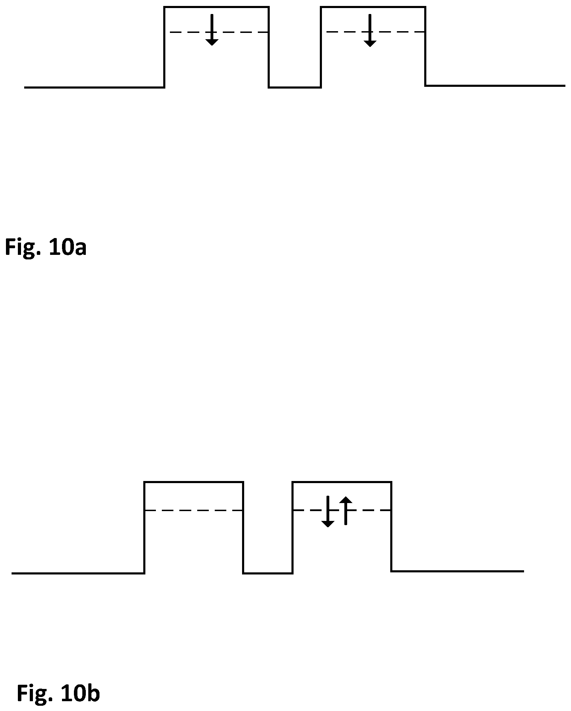

In Fig. 10a, the Triplet (1,1) charge states of the qubit is shown. In Fig. 10b, the Singlet (0,2) charge states of the qubit is shown.

As is readily appreciated by the person skilled in the art, many modifications and variations may be devised given the above description. It is intended that all such modifications and variations be considered as within the scope of description. The invention, however, is only defined by the appended claims.

## Claims

1.    An electron-hole spin qubit transistor (100) comprising:

a base layer (102);
a first qubit (103) comprising:

a first computing semiconductor island (106) and a first readout semiconductor island (108) arranged with a distance in the range of 3-10 nm therebetween;

a second qubit (105) comprising:

a second computing semiconductor island (110) and a second readout semiconductor island (112) arranged with a distance in the range of 3-10 nm therebetween;

wherein each of said semiconductor islands has a size causing each of said semiconductor islands to exhibit 3-dimensional quantum confinement of a single electron hole, and wherein each of said semiconductor islands forms a heterojunction with the base layer;

wherein the spin qubit transistor (100) further comprises:

a supporting material (116) arranged on top of and embedding each of said semiconductor islands;

a source terminal (S) being in electrical contact with the first computing semiconductor island (106) via the supporting material (116);

a drain terminal (D) being in electrical contact with the second computing semiconductor island (110) via the supporting material (116);

a first gate terminal (G1) arranged over the first computing semiconductor island (106), the first gate terminal (G1) being configured for microwave modulation of the spin state of first computing semiconductor island (106);

a second gate terminal (G2) arranged over the first readout semiconductor island (108), the second gate terminal (G2) being configured for readout of a state of the first readout semiconductor island (108);

a third gate terminal (G3) arranged over the second computing semiconductor island (110), the third gate terminal (G3) being configured for microwave modulation of the spin state of second computing semiconductor island (110);

a fourth gate terminal (G4) arranged over the second readout semiconductor island (112), the fourth gate terminal (G4) being configured for readout of a state of the second readout semiconductor island (112);

wherein said first computing semiconductor island (106) and said second computing semiconductor island (110) are configured to have a unique resonance frequency respectively.

2. The electron-hole spin qubit transistor (100) according to claim 1, wherein each semiconductor island comprise an $Al(x)Ga(1-x)N$ alloy, wherein each computing semiconductor island comprise a unique $Al(x)Ga(1-x)N$ alloy, thereby achieving computing semiconductor islands having said unique resonance frequency, wherein the base layer is $Al(y)Ga(1-y)N$ and wherein $x > y$ and $y > 0$.

3. The electron-hole spin qubit transistor (100) according to claim 1, wherein each semiconductor island (106, 108, 110, 112) comprise a lower region comprising an $Al(x)Ga(1-x)N$ alloy, and an upper region comprising GaN, and wherein the base layer is GaN, wherein the heterojunction is formed at an interface of the lower region and the base layer and wherein $x > y$.

4. The electron-hole spin qubit transistor according to claim 1, wherein each semiconductor island has a unique size (106, 108, 110, 112), thereby achieving computing semiconductor islands (106, 110) having said unique resonance frequency.

5. The electron-hole spin qubit transistor (100) according to any of the preceding claims, wherein the first gate terminal (G1) is configured to excite an electron hole to cause the first qubit (103) to transition from a singlet state (S) to a triplet state (T).

6. The electron-hole spin qubit transistor (100) according to claim 5, wherein the first gate terminal (G1) is configured to electrostatically excite said electron hole to cause the first qubit (103) to transition from said singlet state (S) to said triplet state (T).

7. The electron-hole spin qubit transistor (100) according to any of the preceding claims, wherein each of the semiconductor islands (106, 108, 110, 112) consists of a material having a wurtzite crystal structure.

8. The electron-hole spin qubit transistor (100) according to any of the preceding claims, wherein the band structure of semiconductor islands (106, 108, 110, 112) are configured with heavy electron-holes at the origin in k-space by the composition of the base layer (102).

9. A method (1000) for forming an electron-hole spin qubit transistor (100) comprising the steps of:

forming (1001) a hard mask layer (202) on a base layer (102);

forming (1003) a first plurality of nano size cavities (204) in the hard mask layer (202);

exposing (1005) the base layer (102) to semiconductor reactive species, thereby forming a plurality of first compute semiconductor islands (106) in said first plurality of nano size cavities (204);

forming (1007) a second plurality of nano size cavities (206) in the hard mask layer (202);

exposing (1009) the base layer (102) to semiconductor reactive species, thereby forming a plurality of second compute semiconductor islands (110) in said second plurality of nano size cavities (206);

forming (1011) a third plurality of nano size cavities (208) in the hard mask layer (202);

exposing (1013) the base layer (102) to semiconductor reactive species, thereby forming, in said third plurality of nano size cavities (208):

> a plurality of first readout semiconductor islands (108), each of said plurality of first readout semiconductor islands (108) being arranged within a distance in the range of 3-10 nm from each of said plurality of first compute semiconductor islands (110), and
>
> a plurality of second readout semiconductor islands (112), each of said plurality of second readout semiconductor islands (112) being arranged within a distance in the range of 3-10 nm from each of said plurality of second compute semiconductor islands (110);

removing (1015) the hard mask layer by wet etching or plasma etching, and embedding (1017) the formed plurality of first compute semiconductor islands (106), the formed plurality of second compute semiconductor islands (110), and the plurality of first and second readout semiconductor islands (108, 112) in a supporting material (116) laterally overgrown over the semiconductor islands (106, 108, 110, 112);

forming (1019) at least one source terminal (S) being in electrical contact with the plurality of first computing semiconductor islands (106) via the supporting material (116);

forming (1021) at least one drain terminal (D) being in electrical contact with the plurality of second computing semiconductor islands (110) via the supporting material (116);

forming (1023) a plurality of first gate terminals (G1) arranged over each of the plurality of first computing semiconductor islands (106), the plurality of first gate terminals (G1) being configured for microwave modulation of the spin state of each of the plurality of first computing semiconductor islands (106);

forming (1025) a plurality of second gate terminals (G2) arranged over each of the plurality of first readout semiconductor islands (108), the plurality of second gate terminals (G2) being configured for readout of a state of each of the plurality of first readout semiconductor islands (108);

forming (1027) a plurality of third gate terminals (G3) arranged over each of the plurality of second computing semiconductor islands (110), the plurality of third gate terminals (G3) being configured for microwave modulation of the spin state of each of the plurality of second computing semiconductor islands (110);

forming (1029) a plurality of fourth gate terminals (G4) arranged over each of the second readout semiconductor islands (112), the plurality of fourth gate terminals (G4) being configured for readout of a state of each of the plurality of second readout semiconductor islands (112).

10. The method (1000) according to claim 9, further comprising forming a cap layer (120) on each of the plurality of first compute semiconductor islands (106) and each of the plurality of second compute semiconductor islands (108) to configure a heterostructure.

11. A method (2000) for forming an electron-hole spin qubit transistor (100) comprising the steps of:

> providing (2001) a layer structure comprising a plurality of semiconductor layers stacked over each other, each of the plurality of semiconductor layers being a unique alloy;
>
> forming (2003) a first hard mask layer on top of the plurality of semiconductor layers;
>
> forming (2005) a first plurality of nano size cavities through first hard mask layer and extending to a first layer of said plurality of semiconductor layers at a first depth (D1);
>
> exposing (2007) the layer structure to a first semiconductor reactive species, thereby forming a plurality of first compute semiconductor islands (106) in said first plurality of nano size cavities;
>
> forming (2009) a second hard mask layer on top of the plurality of semiconductor layers;
>
> forming (2011) a second plurality of nano size cavities through the second hard mask layer and extending to a second layer of said plurality of semiconductor layers at a second depth (D2);
>
> exposing (2013) the layer structure to a second semiconductor reactive species, thereby forming a plurality of second compute semiconductor islands (110) in said second plurality of nano size cavities;
>
> forming (2015) a third hard mask layer on top of the plurality of semiconductor layers;

forming (2017) a third plurality of nano size cavities through the third hard mask layer and extending to a third layer of said plurality of semiconductor layers at a third depth;

exposing (2019) the layer structure to a third semiconductor reactive species, thereby forming a plurality of first and second readout semiconductor islands (108, 112) in said third plurality of nano size cavities;

wherein the first, second, and third depths differs by at least one layer of said semiconductor layers;

removing (2021) all hard mask layers by wet etching or plasma etching;

embedding (2023) the formed plurality of first compute semiconductor (106) islands, the formed plurality of second compute semiconductor islands (110), and the formed plurality of first and second readout semiconductor islands (108, 112) in a supporting material (116) laterally overgrown over the semiconductor islands;

forming (2025) at least one source terminal (S) being in electrical contact with the plurality of first computing semiconductor islands (106) via the supporting material (116);

forming (2027) at least one drain terminal (D) being in electrical contact with the plurality of second computing semiconductor islands (110) via the supporting material (116);

forming (2029) a plurality of first gate terminals (G1) arranged over each of the plurality of first computing semiconductor islands (106), the plurality of first gate terminals (G1) being configured for microwave modulation of the spin state of each of the plurality of first computing semiconductor islands (106);

forming (2031) a plurality of second gate terminals (G2) arranged over each of the plurality of first readout semiconductor islands (108), the plurality of second gate terminals (G2) being configured for readout of a state of each of the plurality of first readout semiconductor islands (108);

forming (2033) a plurality of third gate terminals (G3) arranged over each of the plurality of second computing semiconductor islands (110), the plurality of third gate terminals (G3) being configured for microwave modulation of the spin state of each of the plurality of second computing semiconductor islands (110);

forming (2035) a plurality of fourth gate terminals (G4) arranged over each of the second readout semiconductor islands (112), the plurality of fourth gate terminals (G4) being configured for readout of a state of each of the plurality of second readout semiconductor islands (112).

12. A quantum computer comprising at least one spin qubit transistor (100) according to any one of claims 1 to 8.

**Patentansprüche**

1. Elektronenloch-Spin-Qubit-Transistor (100), umfassend:

eine Basisschicht (102);
ein erstes Qubit (103), umfassend:

eine erste Berechnungshalbleiterinsel (106) und eine erste Auslesehalbleiterinsel (108), die mit einem Abstand im Bereich von 3-10 nm dazwischen angeordnet sind;
ein zweites Qubit (105), umfassend:

eine zweite Berechnungshalbleiterinsel (110) und eine zweite Auslesehalbleiterinsel (112), die mit einem Abstand im Bereich von 3-10 nm dazwischen angeordnet sind;
wobei jede der Halbleiterinseln eine Größe aufweist, die bewirkt, dass jede der Halbleiterinseln eine dreidimensionale Größenquantisierung eines einzelnen Elektronenlochs aufweist, und wobei jede der Halbleiterinseln einen Heteroübergang mit der Basisschicht bildet;
wobei der Spin-Qubit-Transistor (100) ferner Folgendes umfasst:

ein Trägermaterial (116), das auf jeder der Halbleiterinseln angeordnet ist und diese einbettet;
einen Source-Anschluss (S), der in elektrischem Kontakt mit der ersten Berechnungshalbleiterinsel (106) über das Trägermaterial (116) steht;
einen Drain-Anschluss (D), der in elektrischem Kontakt mit der zweiten Berechnungshalbleiterinsel (110) über das Trägermaterial (116) steht;
einen ersten Gate-Anschluss (G1), der über der ersten Berechnungshalbleiterinsel (106) angeordnet ist, wobei der erste Gate-Anschluss (G1) für eine Mikrowellenmodulation des Spinzustands der ersten Berechnungshalbleiterinsel (106) konfiguriert ist;
einen zweiten Gate-Anschluss (G2), der über der ersten Auslesehalbleiterinsel (108) angeordnet ist, wobei der zweite Gate-Anschluss (G2) zum Auslesen eines Zustands der ersten Auslesehalbleiterinsel (108) konfiguriert ist;

einen dritten Gate-Anschluss (G3), der über der zweiten Berechnungshalbleiterinsel (110) angeordnet ist, wobei der dritte Gate-Anschluss (G3) für eine Mikrowellenmodulation des Spinzustands der zweiten Berechnungshalbleiterinsel (110) konfiguriert ist;

einen vierten Gate-Anschluss (G4), der über der zweiten Auslesehalbleiterinsel (112) angeordnet ist, wobei der vierte Gate-Anschluss (G4) zum Auslesen eines Zustands der zweiten Auslesehalbleiterinsel (112) konfiguriert ist;

wobei die erste Berechnungshalbleiterinsel (106) und die zweite Berechnungshalbleiterinsel (110) dazu konfiguriert sind, jeweils eine eindeutige Resonanzfrequenz aufzuweisen.

2. Elektronenloch-Spin-Qubit-Transistor (100) nach Anspruch 1, wobei jede Halbleiterinsel eine Al(x)Ga(1-x)N-Legierung umfasst, wobei jede Berechnungshalbleiterinsel eine eindeutige Al(x)Ga(1-x)N-Legierung umfasst, wodurch Berechnungshalbleiterinseln erreicht werden, die die eindeutige Resonanzfrequenz aufweisen, wobei die Basisschicht Al(y)Ga(1-y)N ist und wobei x > y und y > 0.

3. Elektronenloch-Spin-Qubit-Transistor (100) nach Anspruch 1, wobei jede Halbleiterinsel (106, 108, 110, 112) einen unteren Bereich, der eine Al(x)Ga(1-x)N-Legierung umfasst, und einen oberen Bereich, der GaN umfasst, umfasst, und wobei die Basisschicht GaN ist, wobei der Heteroübergang an einer Schnittstelle des unteren Bereichs und der Basisschicht gebildet ist und wobei x > y.

4. Elektronenloch-Spin-Qubit-Transistor nach Anspruch 1, wobei jede Halbleiterinsel eine eindeutige Größe (106, 108, 110, 112) aufweist, wodurch Berechnungshalbleiterinseln (106, 110) mit der eindeutigen Resonanzfrequenz erreicht werden.

5. Elektronenloch-Spin-Qubit-Transistor (100) nach einem der vorhergehenden Ansprüche, wobei der erste Gate-Anschluss (G1) dazu konfiguriert ist, ein Elektronenloch anzuregen, um zu bewirken, dass das erste Qubit (103) aus einem Singulettzustand (S) in einen Triplettzustand (T) übergeht.

6. Elektronenloch-Spin-Qubit-Transistor (100) nach Anspruch 5, wobei der erste Gate-Anschluss (G1) dazu konfiguriert ist, das Elektronenloch elektrostatisch anzuregen, um zu bewirken, dass das erste Qubit (103) aus dem Singulettzustand (S) in den Triplettzustand (T) übergeht.

7. Elektronenloch-Spin-Qubit-Transistor (100) nach einem der vorhergehenden Ansprüche, wobei jede der Halbleiterinseln (106, 108, 110, 112) aus einem Material besteht, das eine Wurtzit-Kristallstruktur aufweist.

8. Elektronenloch-Spin-Qubit-Transistor (100) nach einem der vorhergehenden Ansprüche, wobei die Bandstruktur der Halbleiterinseln (106, 108, 110, 112) mit schweren Elektronenlöchern am Ursprung im k-Raum durch die Zusammensetzung der Basisschicht (102) konfiguriert sind.

9. Verfahren (1000) zum Bilden eines Elektronenloch-Spin-Qubit-Transistors (100), die folgenden Schritte umfassend:

Bilden (1001) einer Hartmaskenschicht (202) auf einer Basisschicht (102);
Bilden (1003) einer ersten Vielzahl von Hohlräumen (204) in Nano-Größe in der Hartmaskenschicht (202);
Aussetzen (1005) der Basisschicht (102) gegenüber Halbleiter-reaktiven Spezies, wodurch eine Vielzahl von ersten Berechnungshalbleiterinseln (106) in der ersten Vielzahl von Hohlräumen (204) in Nano-Größe gebildet wird;
Bilden (1007) einer zweiten Vielzahl von Hohlräumen (206) in Nano-Größe in der Hartmaskenschicht (202);
Aussetzen (1009) der Basisschicht (102) gegenüber Halbleiter-reaktiven Spezies, wodurch eine Vielzahl von zweiten Berechnungshalbleiterinseln (110) in der zweiten Vielzahl von Hohlräumen (206) in Nano-Größe gebildet wird;
Bilden (1011) einer dritten Vielzahl von Hohlräumen (208) in Nano-Größe in der Hartmaskenschicht (202);
Aussetzen (1013) der Basisschicht (102) gegenüber Halbleiter-reaktiven Spezies, wodurch in der dritten Vielzahl von Hohlräumen (208) in Nano-Größe Folgendes gebildet wird:

eine Vielzahl von ersten Auslesehalbleiterinseln (108), wobei jede der Vielzahl von ersten Auslesehalbleiterinseln (108) innerhalb eines Abstands im Bereich von 3-10 nm von jeder der Vielzahl von ersten Berechnungshalbleiterinseln (110) angeordnet ist, und
eine Vielzahl von zweiten Auslesehalbleiterinseln (112), wobei jede der Vielzahl von zweiten Auslesehalbleiterinseln (112) innerhalb eines Abstands im Bereich von 3-10 nm von jeder der Vielzahl von zweiten Berechnungshalbleiterinseln (110) angeordnet ist;

Entfernen (1015) der Hartmaskenschicht durch Nassätzen oder Plasmaätzen und Einbetten (1017) der gebildeten Vielzahl von ersten Berechnungshalbleiterinseln (106), der gebildeten Vielzahl von zweiten Berechnungshalbleiterinseln (110) und der Vielzahl von ersten und zweiten Auslesehalbleiterinseln (108, 112) in ein Trägermaterial (116), das die Halbleiterinseln (106, 108, 110, 112) seitlich überwuchert;

Bilden (1019) von mindestens einem Source-Anschluss (S), der in elektrischem Kontakt mit der Vielzahl von ersten Berechnungshalbleiterinseln (106) über das Trägermaterial (116) steht;

Bilden (1021) von mindestens einem Drain-Anschluss (D), der in elektrischem Kontakt mit der Vielzahl von zweiten Berechnungshalbleiterinseln (110) über das Trägermaterial (116) steht;

Bilden (1023) einer Vielzahl von ersten Gate-Anschlüssen (G1), die über jeder der Vielzahl von ersten Berechnungshalbleiterinseln (106) angeordnet sind, wobei die Vielzahl von ersten Gate-Anschlüssen (G1) zur Mikrowellenmodulation des Spinzustands von jeder der Vielzahl von ersten Berechnungshalbleiterinseln (106) konfiguriert ist;

Bilden (1025) einer Vielzahl von zweiten Gate-Anschlüssen (G2), die über jeder der Vielzahl von ersten Auslesehalbleiterinseln (108) angeordnet sind, wobei die Vielzahl von zweiten Gate-Anschlüssen (G2) zum Auslesen eines Zustands von jeder der Vielzahl von ersten Auslesehalbleiterinseln (108) konfiguriert ist;

Bilden (1027) einer Vielzahl von dritten Gate-Anschlüssen (G3), die über jeder der Vielzahl von zweiten Berechnungshalbleiterinseln (110) angeordnet sind, wobei die Vielzahl von dritten Gate-Anschlüssen (G3) zur Mikrowellenmodulation des Spinzustands von jeder der Vielzahl von zweiten Berechnungshalbleiterinseln (110) konfiguriert ist;

Bilden (1029) einer Vielzahl von vierten Gate-Anschlüssen (G4), die über jeder der zweiten Auslesehalbleiterinseln (112) angeordnet sind, wobei die Vielzahl von vierten Gate-Anschlüssen (G4) zum Auslesen eines Zustands von jeder der Vielzahl von zweiten Auslesehalbleiterinseln (112) konfiguriert ist.

10. Verfahren (1000) nach Anspruch 9, ferner umfassend Bilden einer Deckschicht (120) auf jeder der Vielzahl von ersten Berechnungshalbleiterinseln (106) und jeder der Vielzahl von zweiten Berechnungshalbleiterinseln (108), um eine Heterostruktur zu konfigurieren.

11. Verfahren (2000) zum Bilden eines Elektronenloch-Spin-Qubit-Transistors (100), die folgenden Schritte umfassend:

Bereitstellen (2001) einer Schichtstruktur, die eine Vielzahl von Halbleiterschichten umfasst, die übereinandergestapelt sind, wobei jede der Vielzahl von Halbleiterschichten eine einzigartige Legierung ist;

Bilden (2003) einer ersten Hartmaskenschicht auf der Vielzahl von Halbleiterschichten;

Bilden (2005) einer ersten Vielzahl von Hohlräumen in Nano-Größe durch die erste Hartmaskenschicht und Erstreckenlassen zu einer ersten Schicht der Vielzahl von Halbleiterschichten in einer ersten Tiefe (D1);

Aussetzen (2007) der Schichtstruktur gegenüber einer ersten Halbleiter-reaktiven Spezies, wodurch eine Vielzahl von ersten Berechnungshalbleiterinseln (106) in der ersten Vielzahl von Hohlräumen in Nano-Größe gebildet wird;

Bilden (2009) einer zweiten Hartmaskenschicht auf der Vielzahl von Halbleiterschichten;

Bilden (2011) einer zweiten Vielzahl von Hohlräumen in Nano-Größe durch die zweite Hartmaskenschicht und Erstreckenlassen zu einer zweiten Schicht der Vielzahl von Halbleiterschichten in einer zweiten Tiefe (D2);

Aussetzen (2013) der Schichtstruktur gegenüber einer zweiten Halbleiter-reaktiven Spezies, wodurch eine Vielzahl von zweiten Berechnungshalbleiterinseln (110) in der zweiten Vielzahl von Hohlräumen in Nano-Größe gebildet wird;

Bilden (2015) einer dritten Hartmaskenschicht auf der Vielzahl von Halbleiterschichten;

Bilden (2017) einer dritten Vielzahl von Hohlräumen in Nano-Größe durch die dritte Hartmaskenschicht und Erstreckenlassen zu einer dritten Schicht der Vielzahl von Halbleiterschichten in einer dritten Tiefe;

Aussetzen (2019) der Schichtstruktur gegenüber einer dritten Halbleiter-reaktiven Spezies, wodurch eine Vielzahl von ersten und zweiten Auslesehalbleiterinseln (108, 112) in der dritten Vielzahl von Hohlräumen in Nano-Größe gebildet wird;

wobei sich die erste, zweite und dritte Tiefe um mindestens eine Schicht der Halbleiterschichten unterscheiden;

Entfernen (2021) aller Hartmaskenschichten durch Nassätzen oder Plasmaätzen;

Einbetten (2023) der gebildeten Vielzahl von ersten Berechnungshalbleiterinseln (106), der gebildeten Vielzahl von zweiten Berechnungshalbleiterinseln (110) und der gebildeten Vielzahl von ersten und zweiten Auslesehalbleiterinseln (108, 112) in ein Trägermaterial (116), das die Halbleiterinseln seitlich überwuchert;

Bilden (2025) von mindestens einem Source-Anschluss (S), der in elektrischem Kontakt mit der Vielzahl von ersten Berechnungshalbleiterinseln (106) über das Trägermaterial (116) steht;

Bilden (2027) von mindestens einem Drain-Anschluss (D), der in elektrischem Kontakt mit der Vielzahl von zweiten Berechnungshalbleiterinseln (110) über das Trägermaterial (116) steht;

Bilden (2029) einer Vielzahl von ersten Gate-Anschlüssen (G1), die über jeder der Vielzahl von ersten Berechnungshalbleiterinseln (106) angeordnet sind, wobei die Vielzahl von ersten Gate-Anschlüssen (G1) zur Mikrowellenmodulation des Spinzustands von jeder der Vielzahl von ersten Berechnungshalbleiterinseln (106) konfiguriert ist;

Bilden (2031) einer Vielzahl von zweiten Gate-Anschlüssen (G2), die über jeder der Vielzahl von ersten Auslesehalbleiterinseln (108) angeordnet sind, wobei die Vielzahl von zweiten Gate-Anschlüssen (G2) zum Auslesen eines Zustands von jeder der Vielzahl von ersten Auslesehalbleiterinseln (108) konfiguriert ist;

Bilden (2033) einer Vielzahl von dritten Gate-Anschlüssen (G3), die über jeder der Vielzahl von zweiten Berechnungshalbleiterinseln (110) angeordnet sind, wobei die Vielzahl von dritten Gate-Anschlüssen (G3) zur Mikrowellenmodulation des Spinzustands von jeder der Vielzahl von zweiten Berechnungshalbleiterinseln (110) konfiguriert ist;

Bilden (2035) einer Vielzahl von vierten Gate-Anschlüssen (G4), die über jeder der zweiten Auslesehalbleiterinseln (112) angeordnet sind, wobei die Vielzahl von vierten Gate-Anschlüssen (G4) zum Auslesen eines Zustands von jeder der Vielzahl von zweiten Auslesehalbleiterinseln (112) konfiguriert ist.

**12.** Quantencomputer, umfassend mindestens einen Spin-Qubit-Transistor (100) nach einem der Ansprüche 1 bis 8.


**Revendications**

**1.** Transistor à bits quantiques de spin de trou d'électrons (100) comprenant :

une couche de base (102) ;
un premier bit quantique (103) comprenant :

un premier îlot semi-conducteur de calcul (106) et un premier îlot semi-conducteur de lecture (108) agencés avec une distance comprise entre 3 et 10 nm entre eux ;
un second bit quantique (105) comprenant :

un second îlot semi-conducteur de calcul (110) et un second îlot semi-conducteur de lecture (112) agencés à une distance comprise entre 3 et 10 nm entre eux ;
dans lequel chacun desdits îlots semi-conducteurs a une taille amenant chacun desdits îlots semi-conducteurs à présenter un confinement quantique tridimensionnel d'un seul trou d'électron, et dans lequel chacun desdits îlots semi-conducteurs forme une hétérojonction avec la couche de base ;
dans lequel le transistor à bits quantiques de spin de trou d'électrons (100) comprend en outre :
un matériau de support (116) agencé au-dessus de chacun desdits îlots semi-conducteurs et les enrobant :

une borne source (S) étant en contact électrique avec le premier îlot semi-conducteur de calcul (106) via le matériau de support (116) ;
une borne de drain (D) étant en contact électrique avec le second îlot semi-conducteur de calcul (110) via le matériau de support (116) ;
une première borne de grille (G1) agencée sur le premier îlot semi-conducteur de calcul (106), la première borne de grille (G1) étant configurée pour la modulation par micro-ondes de l'état de spin du premier îlot semi-conducteur de calcul (106) ;
une seconde borne de grille (G2) agencée sur le premier îlot semi-conducteur de lecture (108), la seconde borne de grille (G2) étant configurée pour la lecture d'un état du premier îlot semi-conducteur de lecture (108) ;
une troisième borne de grille (G3) agencée sur le second îlot semi-conducteur de calcul (110), la troisième borne de grille (G3) étant configurée pour la modulation par micro-ondes de l'état de spin du second îlot semi-conducteur de calcul (110) ;
une quatrième borne de grille (G4) agencée sur le second îlot semi-conducteur de lecture (112), la quatrième borne de grille (G4) étant configurée pour la lecture d'un état du second îlot semi-conducteur de lecture (112) ;
dans lequel ledit premier îlot semi-conducteur de calcul (106) et ledit second îlot semi-conducteur de calcul (110) sont configurés pour avoir respectivement une fréquence de résonance unique.

2. Transistor à bits quantiques de spin de trou d'électrons (100) selon la revendication 1, dans lequel chaque îlot semi-conducteur comprend un alliage Al(x)Ga(1-x)N, dans lequel chaque îlot semi-conducteur de calcul comprend un alliage Al(x)Ga(1-x)N unique, obtenant ainsi des îlots semi-conducteurs de calcul ayant ladite fréquence de résonance unique, dans lequel la couche de base est Al(y)Ga(1-y)N et dans lequel x > y et y > 0.

3. Transistor à bits quantiques de spin de trou d'électrons (100) selon la revendication 1, dans lequel chaque îlot semi-conducteur (106, 108, 110, 112) comprend une région inférieure comprenant un alliage Al(x)Ga(1-x)N, et une région supérieure comprenant GaN, et dans lequel la couche de base est GaN, dans lequel l'hétérojonction est formée au niveau d'une interface de la région inférieure et de la couche de base et dans lequel x > y.

4. Transistor à bits quantiques de spin de trou d'électrons selon la revendication 1, dans lequel chaque îlot semi-conducteur a une taille unique (106, 108, 110, 112), ce qui permet de calculer des îlots semi-conducteurs (106, 110) ayant ladite fréquence de résonance unique.

5. Transistor à bits quantiques de spin de trou d'électrons (100) selon l'une quelconque des revendications précédentes, dans lequel la première borne de grille (G1) est configurée pour exciter un trou d'électron afin de provoquer la transition du premier bit quantique (103) d'un état singulet (S) à un état triplet (T).

6. Transistor à bits quantiques de spin de trou d'électrons (100) selon la revendication 5, dans lequel la première borne de grille (G1) est configurée pour exciter électrostatiquement ledit trou d'électron pour provoquer la transition du premier bit quantique (103) dudit état singulet (S) vers ledit état triplet (T).

7. Transistor à bits quantiques de spin de trou d'électrons (100) selon l'une quelconque des revendications précédentes, dans lequel chacun des îlots semi-conducteurs (106, 108, 110, 112) est constitué d'un matériau ayant une structure cristalline de wurtzite.

8. Transistor à bits quantiques de spin de trou d'électrons (100) selon l'une quelconque des revendications précédentes, dans lequel la structure de bande des îlots semi-conducteurs (106, 108, 110, 112) est configurée avec des trous d'électrons lourds à l'origine dans l'espace k par la composition de la couche de base (102).

9. Procédé (1000) de formation d'un transistor à bits quantiques de spin de trou d'électrons (100) comprenant les étapes consistant à :

former (1001) une couche de masque dur (202) sur une couche de base (102) ;
former (1003) une première pluralité de cavités de taille nanométrique (204) dans la couche de masque dur (202) ;
exposer (1005) la couche de base (102) à des espèces réactives semi-conductrices, formant ainsi une pluralité de premiers îlots semi-conducteurs de calcul (106) dans ladite première pluralité de cavités de taille nanométrique (204) ;
former (1007) une seconde pluralité de cavités de taille nanométrique (206) dans la couche de masque dur (202) ;
exposer (1009) la couche de base (102) à des espèces réactives semi-conductrices, formant ainsi une pluralité de seconds îlots semi-conducteurs de calcul (110) dans ladite seconde pluralité de cavités de taille nanométrique (206) ;
former (1011) une troisième pluralité de cavités de taille nanométrique (208) dans la couche de masque dur (202) ;
exposer (1013) la couche de base (102) à des espèces réactives semi-conductrices, formant ainsi, dans ladite troisième pluralité de cavités de taille nanométrique (208) :

une pluralité de premiers îlots semi-conducteurs de lecture (108), chacun desdits premiers îlots semi-conducteurs de lecture (108) étant agencé à une distance comprise entre 3 et 10 nm de chacun des premiers îlots semi-conducteurs de calcul (110), et
une pluralité de seconds îlots semi-conducteurs de lecture (112), chacun de ladite pluralité de seconds îlots semi-conducteurs de lecture (112) étant agencé à une distance comprise entre 3 et 10 nm de chacun de ladite pluralité de seconds îlots semi-conducteurs de calcul (110) ;
retirer (1015) la couche de masque dur par gravure humide ou gravure au plasma, et incorporer (1017) la pluralité formée de premiers îlots semi-conducteurs de calcul (106), la pluralité formée de seconds îlots semi-conducteurs de calcul (110) et la pluralité de premiers et seconds îlots semi-conducteurs de lecture (108, 112) dans un matériau de support (116) recouvrant latéralement les îlots semi-conducteurs (106, 108, 110, 112) ;

former (1019) au moins une borne source (S) en contact électrique avec la pluralité de premiers îlots semi-conducteurs de calcul (106) via le matériau de support (116) ;

former (1021) au moins une borne de drain (D) en contact électrique avec la pluralité de seconds îlots semi-conducteurs de calcul (110) via le matériau de support (116) ;

former (1023) une pluralité de premières bornes de grille (G1) agencées sur chacun de la pluralité de premiers îlots semi-conducteurs de calcul (106), la pluralité de premières bornes de grille (G1) étant configurées pour la modulation par micro-ondes de l'état de spin de chacun de la pluralité de premiers îlots semi-conducteurs de calcul (106) ;

former (1025) une pluralité de secondes bornes de grille (G2) agencées sur chacun de la pluralité de premiers îlots semi-conducteurs de lecture (108), la pluralité de secondes bornes de grille (G2) étant configurées pour la lecture d'un état de chacun de la pluralité de premiers îlots semi-conducteurs de lecture (108) ;

former (1027) une pluralité de troisièmes bornes de grille (G3) agencées sur chacun de la pluralité de seconds îlots semi-conducteurs de calcul (110), la pluralité de troisièmes bornes de grille (G3) étant configurées pour la modulation par micro-ondes de l'état de spin de chacun de la pluralité de seconds îlots semi-conducteurs de calcul (110) ;

former (1029) une pluralité de quatrièmes bornes de grille (G4) agencées sur chacun des seconds îlots semi-conducteurs de lecture (112), la pluralité de quatrièmes bornes de grille (G4) étant configurées pour la lecture d'un état de chacun de la pluralité de seconds îlots semi-conducteurs de lecture (112).

10. Procédé (1000) selon la revendication 9, comprenant en outre la formation d'une couche de recouvrement (120) sur chacun de la pluralité de premiers îlots semi-conducteurs de calcul (106) et chacun de la pluralité de seconds îlots semi-conducteurs de calcul (108) pour configurer une hétérostructure.

11. Procédé (2000) de formation d'un transistor à bits quantiques de spin de trou d'électrons (100) comprenant les étapes consistant à :

fournir (2001) une structure de couches comprenant une pluralité de couches semi-conductrices empilées les unes sur les autres, chacune de la pluralité de couches semi-conductrices étant un alliage unique ;

former (2003) une première couche de masque dur au-dessus de la pluralité de couches semi-conductrices ;

former (2005) une première pluralité de cavités de taille nanométrique à travers la première couche de masque dur et s'étendant jusqu'à une première couche de ladite pluralité de couches semi-conductrices à une première profondeur (D1) ;

exposer (2007) la structure de couche à une première espèce réactive semi-conductrice, formant ainsi une pluralité de premiers îlots semi-conducteurs de calcul (106) dans ladite première pluralité de cavités de taille nanométrique ;

former (2009) une seconde couche de masque dur au-dessus de la pluralité de couches semi-conductrices ;

former (2011) une seconde pluralité de cavités de taille nanométrique à travers la seconde couche de masque dur et s'étendant jusqu'à une seconde couche de ladite pluralité de couches semi-conductrices à une seconde profondeur (D2) ;

exposer (2013) la structure de couche à une seconde espèce réactive semi-conductrice, formant ainsi une pluralité de seconds îlots semi-conducteurs de calcul (110) dans ladite seconde pluralité de cavités de taille nanométrique ;

former (2015) une troisième couche de masque dur au-dessus de la pluralité de couches semi-conductrices ;

former (2017) une troisième pluralité de cavités de taille nanométrique à travers la troisième couche de masque dur et s'étendant jusqu'à une troisième couche de ladite pluralité de couches semi-conductrices à une troisième profondeur ;

exposer (2019) la structure de couche à une troisième espèce réactive semi-conductrice, formant ainsi une pluralité de premiers et seconds îlots semi-conducteurs de lecture (108, 112) dans ladite troisième pluralité de cavités de taille nanométrique ;

dans lequel les première, seconde et troisième profondeurs diffèrent d'au moins une couche desdites couches semi-conductrices ;

éliminer (2021) toutes les couches de masque dur par gravure humide ou gravure plasma ;

incorporer (2023) la pluralité formée de premiers îlots semi-conducteurs de calcul (106), la pluralité formée de seconds îlots semi-conducteurs de calcul (110) et la pluralité formée de premiers et seconds îlots semi-conducteurs de lecture (108, 112) dans un matériau de support (116) recouvrant latéralement les îlots semi-conducteurs ;

former (2025) au moins une borne source (S) en contact électrique avec la pluralité de premiers îlots semi-conducteurs de calcul (106) via le matériau de support (116) ;

former (2027) au moins une borne de drain (D) étant en contact électrique avec la pluralité de seconds îlots semi-conducteurs de calcul (110) via le matériau de support (116) ;

former (2029) une pluralité de premières bornes de grille (G1) agencées sur chacun de la pluralité de premiers îlots semi-conducteurs de calcul (106), la pluralité de premières bornes de grille (G1) étant configurées pour la modulation par micro-ondes de l'état de spin de chacun de la pluralité de premiers îlots semi-conducteurs de calcul (106) ;

former (2031) une pluralité de secondes bornes de grille (G2) agencées sur chacun de la pluralité de premiers îlots semi-conducteurs de lecture (108), la pluralité de secondes bornes de grille (G2) étant configurées pour la lecture d'un état de chacun de la pluralité de premiers îlots semi-conducteurs de lecture (108) ;

former (2033) une pluralité de troisièmes bornes de grille (G3) agencées sur chacun de la pluralité de seconds îlots semi-conducteurs de calcul (110), la pluralité de troisièmes bornes de grille (G3) étant configurées pour la modulation par micro-ondes de l'état de spin de chacun de la pluralité de seconds îlots semi-conducteurs de calcul (110) ;

former (2035) une pluralité de quatrièmes bornes de grille (G4) agencées sur chacun des seconds îlots semi-conducteurs de lecture (112), la pluralité de quatrièmes bornes de grille (G4) étant configurées pour la lecture d'un état de chacun de la pluralité de seconds îlots semi-conducteurs de lecture (112).

12. Ordinateur quantique comprenant au moins un transistor à bit quantique de spin (100) selon l'une quelconque des revendications 1 à 8.

**Fig. 1**

**Fig. 2**

**Fig. 3a**

**Fig. 3b**

**Fig. 4a**

**Fig. 4b**

**Fig. 5**

1000

| | |
|---|---|
| 1001 | Forming a hard mask layer on a base layer |
| 1003 | Forming a first plurality of nanosize cavities in the hard mask layer |
| 1005 | Exposing the base layer to a semiconductor reactive species, forming a plurality of first compute semiconductor islands |
| 1007 | Forming a second plurality of nanosize cavities |
| 1009 | Exposing the base layer to semiconductor reactive species, forming a plurality of second compute semiconductor islands |
| 1011 | Forming a third plurality of nanosize cavities |
| 1013 | Exposing the base layer to semiconductor reactive species, forming a plurality of first and second readout semiconductor islands |
| 1015 | Removing the hard mask by wet etching or plasma etching |

| | |
|---|---|
| 1017 | Embedding the formed plurality of semiconductor islands in a supporting material |
| 1019 | Forming at least one source terminal |
| 1021 | Forming at least one drain terminal |
| 1023 | Forming a plurality of first gate terminals |
| 1025 | Forming a plurality of second gate terminals |
| 1027 | Forming a plurality of third gate terminals |
| 1029 | Forming a plurality of fourth gate terminals |
| 1031 | Forming a cap layer on the plurality of first and second compute semiconductor islands |

**Fig. 6**

**Fig. 7a**

**Fig. 7b**

2000

2001 — Providing a layer structure comprising a plurality of semiconductor layers stacked over each other.

2003 — Forming a first hard mask layer on top of the plurality of semiconductor layers.

2005 — Forming a first plurality of nano size cavities through first hard mask layer and extending to a first layer of said plurality of semiconductor layers.

2007 — Exposing the layer structure to a first semiconductor reactive species, forming a plurality of first compute semiconductor islands.

2009 — Forming a second hard mask layer on top of the plurality of semiconductor layers.

2011 — Forming a second plurality of nano size cavities through the second hard mask layer and extending to a second layer of said plurality of semiconductor layers.

2013 — Exposing the layer structure to a second semiconductor reactive species, forming a plurality of second compute semiconductor islands.

2015 — Forming a third hard mask layer on top of the plurality of semiconductor layers.

2017 — Forming a third plurality of nano size cavities through the third hard mask layer and extending to a third layer of said plurality of semiconductor layers.

2019 — Exposing the layer structure to a third semiconductor reactive species, thereby forming a plurality of first and second readout semiconductor islands.

2021 — Removing all hard mask layers by wet etching or plasma etching.

2023 — Embedding the formed plurality of semiconductor islands in a supporting material.

2025 — Forming at least one source terminal.

2027 — Forming at least one drain terminal.

2029 — Forming a plurality of first gate terminals.

2031 — Forming a plurality of second gate terminals

2033 — Forming a plurality of third gate terminals

2035 — Forming a plurality of fourth gate terminals

**Fig. 8**

100

**Fig. 9a**

S    G1         G3    D

110

D2

D1

106

**Fig. 9b**

**Fig. 10a**

**Fig. 10b**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200027972 A1
- US 20190252377 A1

- EP 2075745 A1

**Non-patent literature cited in the description**

- *Scientific Reports*, 2018, vol. 8, 7400
- *Quantum Information*, 2021, vol. 7, 54, https://doi.org/10.1038/s41534-021-00386-2
- **G. MEDEIROS-RIBEIRO et al.** *Appl. Phys. A*, 2003

- **BIRUDAVOLU, S. et al.** Selective area growth of InAs quantum dots formed on a patterned GaAs substrate. *Applied Physics Letters*, 2004, vol. 85, 2337-2339